# EUROPEAN PATENT APPLICATION

(11) **EP 4 621 203 A1**
(43) Date of publication of application: **24.09.2025**
(21) Application number: 25164133.8
(22) Date of filing: 17.03.2025
(51) Int. Cl.: F02C 7/12, B64D 27/33, B64D 31/18, F01D 15/10, F02K 5/00

(54) **AIRCRAFT ENGINE HYBRID ELECTRIC THERMAL MANAGEMENT SYSTEM**

(30) Priority: 18.03.2024 US 202418607660
(71) Applicant: General Electric Company, Cincinnati, Ohio 45215 (US); GE Aerospace Poland Sp. z o.o., 02-256 Warsaw (PL)
(72) Inventor: PAZINSKI, Adam Tomasz, 02-256 Warsaw (PL); MORENO PATAN, Victor, 76146 Queretaro (MX); ZATORSKI, Darek Tomasz, Evendale, 45215 (US); SOBANIEC, Miroslaw, 02-256 Warsaw (PL); NIERGARTH, Daniel Alan, Evendale, 45241 (US); HINDERLITER, Kevin Edward, Evendale, 45241 (US); HIGGINS, Craig William, Evendale, 45241 (US)
(74) Representative: Openshaw & Co.

(57) **Abstract**

A thermal management system (400, 500, 600, 700, 800) defines a thermal management system flowpath (401, 501, 701, 801) to provide a flow of a fluid to an electric machine (300A, 300B, 302A, 402, 504, 802, 804) and a power electronics assembly (404, 818) where the power electronics assembly (404, 818) is electrically connected to the electric machine (300A, 300B, 302A, 402, 504, 802, 804). The thermal management system (400, 500, 600, 700, 800) includes a first heat exchanger (410) thermally connected to the thermal management system flowpath (401, 501, 701, 801) and to the electric machine (300A, 300B, 302A, 402, 504, 802, 804), and a second heat exchanger (412) thermally connected to the thermal management system flowpath (401, 501, 701, 801) downstream of the first heat exchanger (410). The second heat exchanger (412) is thermally connected to the power electronics assembly (404, 818).

## Description

### FIELD

The present disclosure relates to an aeronautical power system including a thermal management system for one or more electric machines which may be incorporated into an aeronautical gas turbine engine.

### BACKGROUND

A conventional commercial aircraft generally includes a fuselage, a pair of wings, and a propulsion system that provides thrust. The propulsion system typically includes at least two aircraft engines, such as turbofan jet engines. Each turbofan jet engine is typically mounted to a respective one of the wings of the aircraft, such as in a suspended position beneath the wing separated from the wing and fuselage.

Hybrid-electric propulsion systems are being developed to improve an efficiency of conventional commercial aircraft. Some hybrid electric propulsion systems include one or more electric machines each being mechanically coupled with a rotating component of one of the aircraft engines. The electric machines can each have an associated power electronics assembly electrically connected thereto including a power converter and power distribution or management units.

### BRIEF DESCRIPTION OF THE DRAWINGS

A full and enabling disclosure of the present disclosure, including the best mode thereof, directed to one of ordinary skill in the art, is set forth in the specification, which makes reference to the appended figures, in which:
FIG. 1 provides a schematic top view of an aircraft having a hybrid-electric propulsion system according to various exemplary embodiments of the present disclosure.
FIG. 2 provides a schematic cross-sectional view of one of the hybrid-electric propulsors of the aircraft of FIG. 1.
FIG. 3 is a simplified, schematic view of a thermal management system for an aeronautical power system in accordance with an exemplary aspect of the present disclosure.
FIG. 4 is a simplified, schematic view of a thermal management system for an aeronautical power system in accordance with another exemplary aspect of the present disclosure.
FIG. 5 is a simplified, schematic view of a thermal management system for an aeronautical power system in accordance with another exemplary aspect of the present disclosure.
FIG. 6 is a simplified, schematic view of a thermal management system for an aeronautical power system in accordance with another exemplary aspect of the present disclosure.
FIG. 7 is a simplified, schematic view of a thermal management system for an aeronautical power system in accordance with another exemplary aspect of the present disclosure.
FIG. 8 depicts a method for thermal management for an aeronautical power system in accordance with an exemplary aspect of the present disclosure.
FIG. 9 provides an example computing system according to example embodiments of the present disclosure.

### DETAILED DESCRIPTION

Reference will now be made in detail to present embodiments of the disclosure, one or more examples of which are illustrated in the accompanying drawings. The detailed description uses numerical and letter designations to refer to features in the drawings. Like or similar designations in the drawings and description have been used to refer to like or similar parts of the disclosure.

The word "exemplary" is used herein to mean "serving as an example, instance, or illustration." Any implementation described herein as "exemplary" is not necessarily to be construed as preferred or advantageous over other implementations. Additionally, unless specifically identified otherwise, all embodiments described herein should be considered exemplary.

The singular forms "a", "an", and "the" include plural references unless the context clearly dictates otherwise.

The term "at least one of" in the context of, e.g., "at least one of A, B, and C" refers to only A, only B, only C, or any combination of A, B, and C.

As used herein, the terms "first", "second", and "third" may be used interchangeably to distinguish one component from another and are not intended to signify location or importance of the individual components.

The terms "forward" and "aft" refer to relative positions within a gas turbine engine or vehicle, and refer to the normal operational attitude of the gas turbine engine or vehicle. For example, with regard to a gas turbine engine, forward refers to a position closer to an engine inlet and aft refers to a position closer to an engine nozzle or exhaust.

The terms "upstream" and "downstream" refer to the relative direction with respect to a flow in a pathway. For example, with respect to a fluid flow, "upstream" refers to the direction from which the fluid flows, and "downstream" refers to the direction to which the fluid flows. However, the terms "upstream" and "downstream" as used herein may also refer to a flow of electricity.

The integration of electric machines with varied power ratings (e.g., a low pressure (LP) electric machine rotatable with an LP system of an engine rated at a higher power than a high pressure (HP) electric machine rotatable with an HP system of the engine) within a restricted space of a gas turbine engine may provide several challenges. For example, by having separate power ratings, thermal management becomes more complex as there are more tailored thermal needs for each of the various components associated with LP and HP electric machines, including the power electronics assemblies electrically connected to the LP and HP electric machines that convert and distribute power to the various components of the gas turbine engine or aircraft.

In order to address the above issues, the present disclosure provides a thermal management system tailored to meet the thermal needs of the LP and HP electric machines and the power distribution components associated with the LP and HP electric machines. The present disclosure provides dedicated or separate cooling loops for the hybrid electric systems. Each cooling loop provides thermal management for the LP and HP electric machines and the power converter and distribution electronic assemblies associated with the LP and HP electric machines to meet the unique thermal requirements of the foregoing. In exemplary embodiments, these cooling loops are separate from other engine cooling loops and include both the electric machine and the power electronics assemblies electrically connected to the electric machine.

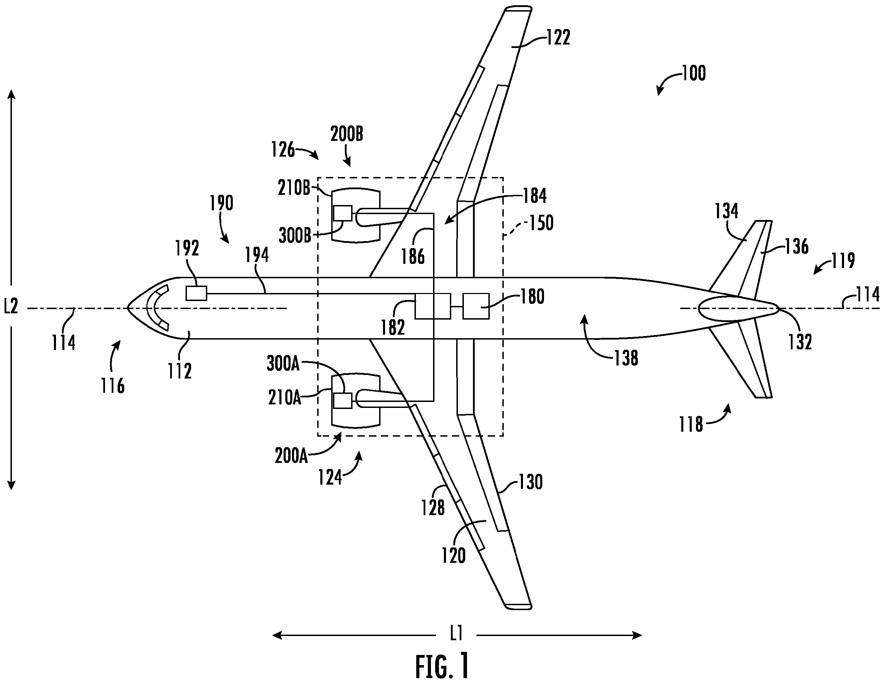

Referring now to the drawings, wherein identical numerals indicate the same elements throughout the figures, FIG. 1 provides a schematic top view of an exemplary aircraft 100 as may incorporate one or more aspects of the present disclosure. As shown in FIG. 1, for reference, the aircraft 100 defines a longitudinal direction L1 and a lateral direction L2. The lateral direction L2 is perpendicular to the longitudinal direction L1. The aircraft 100 also defines a longitudinal centerline 114 that extends therethrough along the longitudinal direction L1. The aircraft 100 extends between a forward end 116 and an aft end 118, e.g., along the longitudinal direction L1.

As depicted, the aircraft 100 includes a fuselage 112 that extends longitudinally from the forward end 116 of the aircraft 100 to the aft end 118 of the aircraft 100. The aircraft 100 also includes an empennage 119 at the aft end 118 of the aircraft 100. In addition, the aircraft 100 includes a wing assembly including a first wing 120 (e.g., a port side wing) and a second wing 122 (e.g., a starboard side wing). The first and second wings 120, 122 each extend laterally outward with respect to the longitudinal centerline 114. The first wing 120 and a portion of the fuselage 112 together define a first side 124 of the aircraft 100 and the second wing 122 and another portion of the fuselage 112 together define a second side 126 of the aircraft 100. For the embodiment depicted, the first side 124 of the aircraft 100 is configured as the port side of the aircraft 100 and the second side 126 of the aircraft 100 is configured as the starboard side of the aircraft 100.

The aircraft 100 includes various control surfaces. For this embodiment, each wing 120, 122 includes one or more leading edge flaps 128 and one or more trailing edge flaps 130. The aircraft 100 further includes, or more specifically, the empennage 119 of the aircraft 100 includes a vertical stabilizer 132 having a rudder flap (not shown) for yaw control and a pair of horizontal stabilizers 134 each having an elevator flap 136 for pitch control. The fuselage 112 additionally includes an outer surface or skin 138. It should be appreciated that in other exemplary embodiments of the present disclosure, the aircraft 100 may additionally or alternatively include any other suitable configuration. For example, in other embodiments, the aircraft 100 may include any other control surface configuration.

The exemplary aircraft 100 of FIG. 1 also includes a hybrid-electric propulsion system 150. For this embodiment, the hybrid-electric propulsion system 150 has a first propulsor 200A and a second propulsor 200B both operable to produce thrust. The first propulsor 200A is mounted to the first wing 120 and the second propulsor 200B is mounted to the second wing 122. Moreover, for the embodiment depicted, the first propulsor 200A and second propulsor 200B are each configured in an underwing-mounted configuration. However, in other example embodiments, one or both of the first and second propulsors 200A, 200B may be mounted at any other suitable location in other exemplary embodiments.

The first propulsor 200A includes a gas turbine engine 210A and one or more electric machines, such as electric machine 300A mechanically coupled with the gas turbine engine 210A. The electric machine 300A can be an electric generator, an electric motor, or a combination generator/motor. For this example embodiment, the electric machine 300A is a combination generator/motor. In this manner, when operating as an electric generator, the electric machine 300A can generate electrical power when driven by the gas turbine engine 210A. When operating as an electric motor, the electric machine 300A can drive or motor the gas turbine engine 210A.

Likewise, the second propulsor 200B includes a gas turbine engine 210B and one or more electric machines, such as electric machine 300B mechanically coupled with the gas turbine engine 210B. The electric machine 300B can be an electric generator, an electric motor, or a combination generator/motor. For this example embodiment, the electric machine 300B is a combination generator/motor. In this manner, when operating as an electric generator, the electric machine 300B can generate electrical power when driven by the gas turbine engine 210B. When operating as an electric motor, the electric machine 300B can drive or motor a spool of the gas turbine engine 210B. Electric machine 300B can be configured and can operate in a similar manner as electric machine 300A described herein.

The hybrid-electric propulsion system 150 further includes an electric energy storage unit 180 electrically connectable to the electric machines 300A, 300B, and in some embodiments, other electrical loads. In some exemplary embodiments, the electric energy storage unit 180 may include one or more batteries. Additionally, or alternatively, the electric energy storage units 180 may include one or more supercapacitor arrays, one or more ultracapacitor arrays, or both. For the hybrid-electric propulsion system 150 described herein, the electric energy storage unit 180 is configured to store a relatively large amount of electrical power. For example, in certain exemplary embodiments, the electric energy storage unit 180 may be configured to store at least about fifty kilowatt hours of electrical power, such as about seventy-five kilowatt hours of electrical power, and up to about one thousand kilowatt hours of electrical power.

The hybrid-electric propulsion system 150 also includes a power management system having a controller 182 and a power bus 184. The electric machines 300A, 300B, the electric energy storage unit 180, and the controller 182 are each electrically connectable to one another through one or more electric lines 186 of the power bus 184.

The controller 182 is configured to control the power electronics to distribute electrical power between the various components of the hybrid-electric propulsion system 150. For example, the controller 182 may control the power electronics of the power bus 184 to provide electrical power to, or draw electrical power from, the various components, such as the electric machines 300A, 300B, to operate the hybrid-electric propulsion system 150 between various operating modes and perform various functions. Such is depicted schematically as the electric lines 186 of the power bus 184 extend through the controller 182.

The controller 182 can form a part of a computing system 190 of the aircraft 100. The computing system 190 of the aircraft 100 can include one or more processors and one or more memory devices embodied in one or more computing devices. For instance, as depicted in FIG. 1, the computing system 190 includes controller 182 as well as other computing devices, such as computing device 192. The computing system 190 can include other computing devices as well, such as engine controllers (not shown). The computing devices of the computing system 190 can be communicatively coupled with one another via a communication network. For instance, computing device 192 is located in the cockpit of the aircraft 100 and is communicatively coupled with the controller 182 of the hybrid-electric propulsion system 150 via a communication link 194 of the communication network. The communication link 194 can include one or more wired or wireless communication links.

For this embodiment, the computing device 192 is configured to receive and process inputs, e.g., from a pilot or other crew members, and/or other information. In this manner, as one example, the one or more processors of the computing device 192 can receive an input indicating a command to change a thrust output of the first and/or second propulsors 200A, 200B and can cause, in response to the input, the controller 182 to control the electrical power drawn from or delivered to one or both of the electric machines 300A, 300B to ultimately change the thrust output of one or both of the propulsors 200A, 200B.

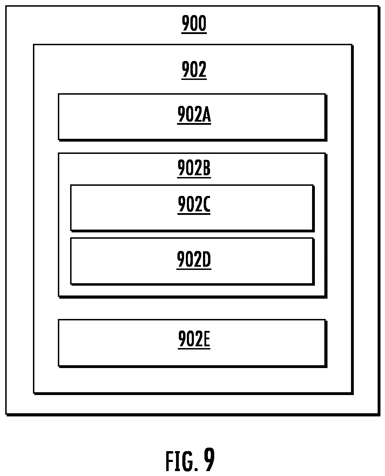

The controller 182 and other computing devices of the computing system 190 of the aircraft 100 may be configured in substantially the same manner as the exemplary computing devices of the computing system 900 described below with reference to FIG. 9.

It will be appreciated that the electric machines 300A, 300B, electric energy storage unit 180, and power management system (having the controller 182 and the power bus 184) may more specifically be configured as part of an aeronautical power system integrated with the gas turbine engines of the hybrid-electric propulsion system 150.

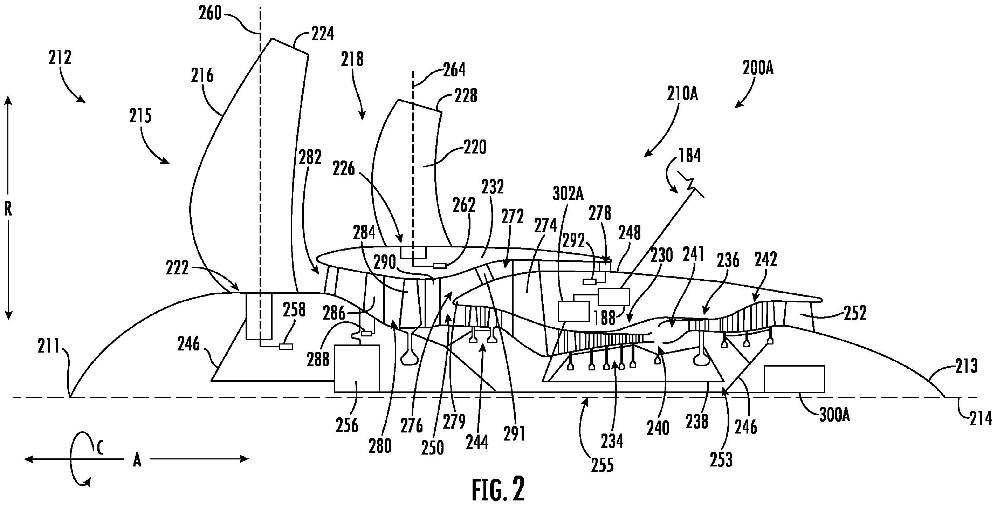

FIG. 2 provides a schematic view of the first propulsor 200A of the hybrid-electric propulsion system 150 of the aircraft 100 of FIG. 1. Although the first propulsor 200A is shown, it will be appreciated that the second propulsor 200B can be configured in the same or similar manner as the first propulsor 200A depicted in FIG. 2. The exemplary gas turbine engine 210A of FIG. 2 is configured as a single unducted rotor engine 210A with a single stage of unducted rotor blades. In such a manner, the rotor assembly may be referred to herein as an "unducted fan," or the entire gas turbine engine 210A may be referred to as an "unducted turbofan engine." In addition, the gas turbine engine 210A of FIG. 2 includes a third stream extending from the compressor section to a rotor assembly flowpath over the turbomachine, as will be explained in more detail below.

For reference, the gas turbine engine 210A defines an axial direction A, a radial direction R, and a circumferential direction C. Moreover, the gas turbine engine 210A defines an axial centerline or longitudinal axis 214 that extends along the axial direction A. In general, the axial direction A extends parallel to the longitudinal axis 214, the radial direction R extends outward from and inward to the longitudinal axis 214 in a direction orthogonal to the axial direction A, and the circumferential direction extends three hundred sixty degrees (360°) around the longitudinal axis 214. The gas turbine engine 210A extends between a forward end 211 and an aft end 213, e.g., along the axial direction A.

The gas turbine engine 210A includes a turbomachine 230 and a rotor assembly 212, also referred to as a fan section, positioned upstream thereof. Generally, the turbomachine 230 includes, in serial flow order, a compressor section, a combustion section, a turbine section, and an exhaust section. Particularly, as shown in FIG. 2, the turbomachine 230 includes a core cowl 248 that defines an annular core inlet 250. The core cowl 248 further encloses at least in part a low speed or low pressure system and a high speed or high pressure system. For example, the core cowl 248 depicted encloses and supports at least in part a booster or low speed or low pressure compressor 244 for pressurizing the air that enters the turbomachine 230 through core inlet 250. A high speed or high pressure, multi-stage, axial-flow compressor (referred to herein as a high pressure compressor 234) receives pressurized air from the low pressure compressor 244 and further increases the pressure of the air. The pressurized air stream flows downstream to a combustor 240 of the combustion section where fuel is injected into the pressurized air stream and ignited to raise the temperature and energy level of the pressurized air.

It will be appreciated that as used herein, the terms "high/low speed" and "high/low pressure" are used with respect to the high pressure/high speed system and low pressure/low speed system interchangeably. Further, it will be appreciated that the terms "high" and "low" are used in this same context to distinguish the two systems, and are not meant to imply any absolute speed and/or pressure values.

The high energy combustion products flow from the combustor 240 downstream to a high pressure turbine 236. The high pressure turbine 236 drives the high pressure compressor 234 through a high pressure shaft 238. In this regard, the high pressure turbine 236 is drivingly coupled with the high pressure compressor 234. The high pressure compressor 234, the high pressure turbine 236, and the high pressure shaft 238 may collectively be referred to as a high speed spool 253 of the gas turbine engine 210A. The high energy combustion products then flow to a low pressure turbine 242. The low pressure turbine 242 drives the low pressure compressor 244 and components of the rotor assembly 212 through a low pressure shaft 246. In this regard, the low pressure turbine 242 is drivingly coupled with the low pressure compressor 244 and components of the rotor assembly 212. The low pressure compressor 244, the low pressure turbine 242, and the low pressure shaft 246 may collectively be referred to as a low speed spool 255 of the gas turbine engine 210A. The low pressure shaft 246 is coaxial with the high pressure shaft 238 in this example embodiment. After driving each of the turbines 236, 242, the combustion products exit the turbomachine 230 through a turbomachine exhaust nozzle 252.

Accordingly, the turbomachine 230 defines a working gas flowpath or core duct 241 that extends between the core inlet 250 and the turbomachine exhaust nozzle 252. The core duct 241 is an annular duct positioned generally inward of the core cowl 248 along the radial direction R. The core duct 241 (e.g., the working gas flowpath through the turbomachine 230) may be referred to as a second stream.

The rotor assembly 212 includes a fan 215, which is the primary fan in this example embodiment. For the depicted embodiment of FIG. 2, the fan 215 is an open rotor or unducted fan. In such a manner, the gas turbine engine 210A may be referred to as an open rotor engine. However, it should be understood that embodiments of the present disclosure are also applicable to other types of engines such as, by way of non-limiting example, a ducted gas turbine engine.

As depicted, the fan 215 includes an array of airfoils arranged around the longitudinal axis 214 of the gas turbine engine 210A, and more particularly includes an array of fan blades 216 (only one shown in FIG. 2) arranged around the longitudinal axis 214 of the gas turbine engine 210A. The fan blades 216 are rotatable, e.g., about the longitudinal axis 214. As noted above, the fan 215 is drivingly coupled with the low pressure turbine 242 via the low pressure shaft 246. For the embodiments shown in FIG. 2, the fan 215 is coupled with the low pressure shaft 246 via a power or speed reduction gearbox 256, e.g., in an indirect-drive or geared-drive configuration.

Moreover, the array of fan blades 216 can be arranged in equal spacing around the longitudinal axis 214. Each fan blade 216 has a proximal end or root 222 and a distal end or tip 224, with respect to the longitudinal axis 214, and a span defined therebetween. Each fan blade 216 defines a pitch change or central blade axis 260. For this embodiment, each fan blade 216 of the rotor assembly 212 is rotatable about its central blade axis 260, e.g., in unison with one another. A pitch change mechanism 258 in the form or one or more actuators is provided to facilitate such rotation and therefore may be used to change a pitch of the fan blades 216 about their respective central blade axes 260.

An array of airfoils positioned aft of the fan blades 216 and also disposed around longitudinal axis 214, and more particularly includes a fan guide vane assembly 218 that includes fan guide vanes 220 (only one shown in FIG. 2) disposed around the longitudinal axis 214. For this embodiment, the fan guide vanes 220 are not rotatable about the longitudinal axis 214. Each fan guide vane 220 has a proximal end or root 226 and a distal end or tip 228, with respect to the longitudinal axis 214, and a span defined therebetween. The fan guide vanes 220 may be unshrouded as shown in FIG. 2 or, alternatively, may be shrouded, e.g., by an annular shroud spaced outward from the tips of the fan guide vanes 220 along the radial direction R or attached to the fan guide vanes 220.

Each fan guide vane 220 defines a central guide vane axis 264. For this embodiment, each fan guide vane 220 of the fan guide vane assembly 218 is rotatable about its respective central guide vane axis 264, e.g., in unison with one another. One or more pitch change mechanisms 262 in the form of one or more actuators are provided to facilitate such rotation and therefore may be used to change a pitch of the fan guide vane 220 about its respective central guide vane axis 264. However, in other embodiments, each fan guide vane 220 may be fixed or unable to be pitched about its central guide vane axis 264. The fan guide vanes 220 are mounted to a fan cowl 232.

As shown in FIG. 2, in addition to the fan 215, which is unducted, a ducted fan 284 is included aft of the fan 215, such that the gas turbine engine 210A includes both a ducted and an unducted fan which both serve to generate thrust through the movement of air without passage through at least a portion of the turbomachine 230 (e.g., without passage through the high pressure compressor 234 and combustion section for the embodiment depicted). The ducted fan 284 is rotatable about the same axis (e.g., the longitudinal axis 214) as the fan blade 216. The ducted fan 284 is, for the embodiment depicted, driven by the low pressure turbine 242 (e.g. coupled to the low pressure shaft 246). In the embodiment depicted, as noted above, the fan 215 may be referred to as the primary fan, and the ducted fan 284 may be referred to as a secondary fan. It will be appreciated that these terms "primary" and "secondary" are terms of convenience, and do not imply any particular importance, power, or the like.

The ducted fan 284 includes a plurality of fan blades (not separately labeled in FIG. 2) arranged in a single stage, such that the ducted fan 284 may be referred to as a single stage fan. The fan blades of the ducted fan 284 can be arranged in equal spacing around the longitudinal axis 214. Each blade of the ducted fan 284 has a proximal end or root and a distal end or tip and a span defined therebetween.

The fan cowl 232 annularly encases at least a portion of the core cowl 248 and is generally positioned outward of at least a portion of the core cowl 248 along the radial direction R. Particularly, a downstream section of the fan cowl 232 extends over a forward portion of the core cowl 248 to define a fan duct flowpath, or simply a fan duct 272. According to this embodiment, the fan flowpath or fan duct 272 may be understood as forming at least a portion of the third stream of the gas turbine engine 210A.

Incoming air may enter through the fan duct 272 through a fan duct inlet 276 and may exit through a fan exhaust nozzle 278 to produce propulsive thrust. The fan duct 272 is an annular duct positioned generally outward of the core duct 241 along the radial direction R. The fan cowl 232 and the core cowl 248 are connected together and supported by a plurality of substantially radially-extending, circumferentially-spaced stationary struts 274 (only one shown in FIG. 2). The stationary struts 274 may each be aerodynamically contoured to direct air flowing thereby. Other struts in addition to the stationary struts 274 may be used to connect and support the fan cowl 232, the core cowl 248, or both. In many embodiments, the fan duct 272 and the core duct 241 may at least partially co-extend (generally axially) on opposite sides (e.g., opposite radial sides) of the core cowl 248. For example, the fan duct 272 and the core duct 241 may each extend directly from a leading edge 279 of the core cowl 248 and may partially co-extend generally axially on opposite radial sides of the core cowl 248.

The gas turbine engine 210A also defines or includes an inlet duct 280. The inlet duct 280 extends between an engine inlet 282 and the core inlet 250 and fan duct inlet 276. The engine inlet 282 is defined generally at the forward end of the fan cowl 232 and is positioned between the fan 215 and the fan guide vane assembly 218 along the axial direction A. The inlet duct 280 is an annular duct that is positioned inward of the fan cowl 232 along the radial direction R. Air flowing downstream along the inlet duct 280 is split, not necessarily evenly, into the core duct 241 and the fan duct 272 by a fan duct splitter or leading edge 279 of the core cowl 248. In the embodiment depicted, the inlet duct 280 is wider than the core duct 241 along the radial direction R. The inlet duct 280 is also wider than the fan duct 272 along the radial direction R.

Notably, for the embodiment depicted, the gas turbine engine 210A includes one or more features to increase an efficiency of a third stream thrust, Fn_{3S} (e.g., a thrust generated by an airflow through the fan duct 272 exiting through the fan exhaust nozzle 278, generated at least in part by the ducted fan 284). In particular, the gas turbine engine 210A further includes an array of inlet guide vanes 286 positioned in the inlet duct 280 upstream of the ducted fan 284 and downstream of the core inlet 250. The array of inlet guide vanes 286 are arranged around the longitudinal axis 214. For this embodiment, the inlet guide vanes 286 are not rotatable about the longitudinal axis 214. Each inlet guide vane 286 defines a central blade axis (not labeled for clarity), and is rotatable about its respective central blade axis, e.g., in unison with one another. In such a manner, the inlet guide vanes 286 may be considered a variable geometry component. One or more actuators 288 are provided to facilitate such rotation and therefore may be used to change a pitch of the inlet guide vanes 286 about their respective central blade axes. However, in other embodiments, each inlet guide vane 286 may be fixed or unable to be pitched about its central blade axis.

Further, located downstream of the ducted fan 284 and upstream of the fan duct inlet 276, the gas turbine engine 210A includes an array of outlet guide vanes 290. As with the array of inlet guide vanes 286, the array of outlet guide vanes 290 are not rotatable about the longitudinal axis 214. However, for the embodiment depicted, unlike the array of inlet guide vanes 286, the array of outlet guide vanes 290 are configured as fixed-pitch outlet guide vanes.

Further, it will be appreciated that for the embodiment depicted, the fan exhaust nozzle 278 of the fan duct 272 is further configured as a variable geometry exhaust nozzle 278. In such a manner, the gas turbine engine 210A includes one or more actuators 292 for modulating the variable geometry exhaust nozzle 278. For example, the variable geometry fan exhaust nozzle 278 may be configured to vary a total cross-sectional area (e.g., an area of the nozzle in a plane perpendicular to the longitudinal axis 214) to modulate an amount of thrust generated based on one or more engine operating conditions (e.g., temperature, pressure, mass flowrate, etc. of an airflow through the fan duct 272). A fixed geometry exhaust nozzle may also be adopted.

Moreover, referring still to FIG. 2, in exemplary embodiments, air passing through the fan duct 272 may be relatively cooler (e.g., lower temperature) than one or more fluids utilized in the turbomachine 230. In this way, one or more heat exchangers 291 may be positioned in thermal communication with the fan duct 272. For example, one or more heat exchangers 291 may be disposed within the fan duct 272 and utilized to cool one or more fluids from the core engine with the air passing through the fan duct 272, as a resource for removing heat from a fluid, e.g., compressor bleed air, oil or fuel.

Referring still to FIG. 2, as noted, the first propulsor 200A includes electric machine 300A operably coupled with a rotating component thereof. In this regard, the first propulsor 200A is an aeronautical hybrid-electric propulsion machine. Particularly, as shown in FIG. 2, the electric machine 300A is mechanically coupled with the low speed spool 255 of the gas turbine engine 210A, and more particularly, the low pressure shaft 246 of the low speed spool 255. As depicted, the electric machine 300A is embedded within the core of the gas turbine engine 210A. Specifically, the electric machine 300A is positioned inward of the core duct 241 along the radial direction R. Moreover, for this embodiment, the electric machine 300A is positioned generally at the aft end of the gas turbine engine 210A and is at least partially overlapping with or aft of the low pressure turbine 242 along the axial direction A.

However, in other exemplary embodiments, the electric machine 300A may be positioned at other suitable locations within the gas turbine engine 210A. For instance, in some embodiments, the electric machine 300A can be coupled with the low speed spool 255 in other suitable locations. For instance, in some embodiments, the electric machine 300A can be positioned forward of the low pressure compressor 244 along the axial direction A and inward of the turbomachinery flowpath 254 along the radial direction R. Further, as shown in FIG. 2, the electric machine 300A mechanically coupled with the low pressure shaft 246 is electrically coupled with the power bus 184.

In addition or alternatively to the gas turbine engine 210A having electric machine 300A coupled to the low speed spool 255, in the embodiment depicted, the gas turbine engine 210A further includes an electric machine 302A mechanically coupled with the high speed spool 253 of the gas turbine engine 210A, and more particularly, the high pressure shaft 238 of the high speed spool 253. As depicted in FIG. 2, the electric machine 302A is mechanically coupled with the high pressure shaft 238 through a mechanical linkage. The electric machine 302A is positioned outward of the core duct 241 along the radial direction R and is positioned forward of the combustion section of the gas turbine engine 210A along the axial direction A.

However, in other exemplary embodiments, the electric machine 302A may be positioned at other suitable locations within the gas turbine engine 210A (e.g., inward of the core duct 241 along the radial direction R).

Like the electric machine 300A mechanically coupled with the low speed spool 255, the electric machine 302A mechanically coupled with the high speed spool 253 can be an electric motor operable to drive or motor the high pressure shaft 238, e.g., during a starting operation of the gas turbine engine 210A. In other embodiments, the electric machine 302A can be an electric generator operable to convert mechanical energy into electrical energy. In this way, electrical power generated by the electric machine 302A can be directed to various engine and/or aircraft systems. In some embodiments, the electric machine 302A can be a motor/generator with dual functionality.

Further, as shown in FIG. 2, the electric machine 302A mechanically coupled with the high pressure shaft 238 is also electrically coupled with the power bus 184. More specifically, the aeronautical power system may included a power electronics assembly 188 located between the electric machines 300A, 302A and the power bus 184. The power electronics assembly 188 may comprise one or more power inverters, power controllers, or other types of electronic components in electric connection with one or more electric power loads, electric power sources, or both (e.g., of the engine or the aircraft, or both).

Additionally or alternatively, in other exemplary embodiments, any other suitable gas turbine engine may be provided. For example, in other exemplary embodiments, the gas turbine engine may be a turboshaft engine, a turboprop engine, turbojet engine, etc. Moreover, for example, although the engine is depicted as a single unducted rotor engine, in other embodiments, the engine may include a multi-stage open rotor configuration, and aspects of the disclosure described hereinbelow may be incorporated therein.

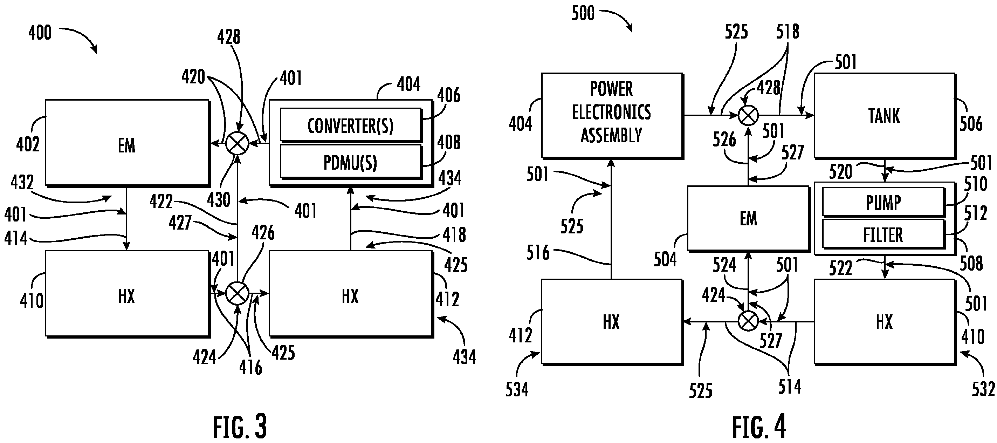

Referring now to FIG. 3, a simplified, schematic view is provided of a thermal management system 400 in accordance with an exemplary aspect of the present disclosure. The exemplary thermal management system 400 of FIG. 3 may be incorporated into one or more of the gas turbine engines 210A, 210B and/or aircraft 100 described herein, or in any other suitable engine and/or aircraft.

A thermal management system flowpath 401 is defined by thermal management system 400 and is a flowpath for a flow of a fluid that flows to, through, or both, the components of the thermal management system 400. The thermal management system flowpath 401 may comprise one or more conduits, tubes, pipes, paths or passageways, walls, or other structure for flowing to, through, or both, the components of the thermal management system 400. The fluid can be of a suitable temperature for thermal energy transfer for a desired or particular function corresponding to the components of the thermal management system 400. In exemplary embodiments, the fluid comprises oil. However, it should be understood that the fluid flowing via the thermal management system flowpath 401 may comprise any suitable fluid for thermal energy transfer such as, by way of non-limiting examples, supercritical gases (e.g., carbon dioxide (CO₂), nitrogen (N₂), Helium (He), Xenon (Xe), and other gaseous mixtures), ethylene glycol, propylene glycol, Dow Corning's Syltherm^{™}, or Exxon Mobil's Coolanol^{™}.

The exemplary thermal management system 400 generally includes an electric machine 402. The electric machine 402 is thermally connected to the thermal management system flowpath 401. The electric machine 402 may be rotatable with a first rotating component of an engine when the thermal management system 400 is integrated with the engine. For example, in certain exemplary embodiments, the electric machine 402 may be a LP electric machine rotatable with a low pressure spool of the engine (e.g., low speed spool 255 of the gas turbine engine 210A in FIG. 2), or the electric machine 402 may be a HP electric machine rotatable with a high pressure spool of the engine (e.g., high speed spool 253 of the gas turbine engine 210A in FIG. 2).

Referring still to FIG. 3, the exemplary thermal management system 400 depicted further includes a power electronics assembly 404 electrically connected to the electric machine 402. The power electronics assembly 404 is thermally connected to the thermal management system flowpath 401 and to the electric machine 402. The power electronics assembly 404 may comprise the power electronics assembly 188 incorporated into one or more of the gas turbine engines 210A, 210B, aircraft 100, or both (FIGS. 1 and 2). The power electronics assembly 404 may comprise one or more power converters 406 and one or more power controllers, and more specifically, one or more power distribution and monitoring units 408 (referred to herein as a "PDMU"), in electric connection with the one or more power converters 406, as well as with one or more electric power loads, electric power sources, or both (e.g., of the engine or the aircraft, or both). In such a manner, the one or more PDMUs 408 may receive electric power from the one or more power converters 406 and may distribute the electric power to one or more electric power loads of the engine and the aircraft, e.g., in response to one or more commands or other data inputs. Of course, in other embodiments, the directional flow of electric power may be reversed. It will be appreciated that the PDMUs 408 may include a computing device(s) configured in substantially the same manner as the exemplary computing devices of the computing system 900 described below with reference to FIG. 9. In such a manner, the PDMUs 408 may be configured to receive one or more data inputs, and may make control decisions in response to the one or more data inputs.

The exemplary thermal management system 400 depicted further includes a first heat exchanger 410 and a second heat exchanger 412. The first heat exchanger 410 is thermally connected to the thermal management system flowpath 401 and to the electric machine 402. The second heat exchanger 412 is each thermally connected to the thermal management system flowpath 401, the first heat exchanger 410, and the power electronics assembly 404. The first heat exchanger 410 and the second heat exchanger 412 may be located in the fan duct 272 (FIG. 2), such as the heat exchanger 291 (FIG. 2), exposed to overboard air, located in within the core cowl 248 (FIG. 2), or elsewhere within the gas turbine engine 210A (FIGS. 1 and 2). The first heat exchanger 410 and the second heat exchanger 412 could be gas-gas, gas-liquid, liquid-liquid heat exchangers or thermoelectric devices. Heat sink fluid associated with the first heat exchanger 410 and the second heat exchanger 412 could be fuel, water, water from an aircraft lavatory system, refrigerant from an environmental control system of an aircraft, or other suitable thermal transfer fluid.

In the illustrated embodiment, the electric machine 402 is fluidly connected to the first heat exchanger 410 via a line 414. Line 414 defines, in part, the thermal management system flowpath 401. As used herein, a "line" may comprise any type of structure (e.g., conduits, tubes, pipes, paths or passageways, walls, etc.) for enabling the passage or flow of a fluid. The first heat exchanger 410 is located downstream from the electric machine 402 based on a flow direction of the fluid flowing through the thermal management system flowpath 401. In exemplary embodiments, the electric machine 402 may comprise a generator and motor with an integrated fluid tank, fluid pump, and fluid filter. The fluid pump may be an electric pump or a mechanical pump.

The first heat exchanger 410 is fluidly connected to the second heat exchanger 412 via a line 416. Line 416 defines, in part, the thermal management system flowpath 401. The second heat exchanger 412 is located downstream from the first heat exchanger 410 based on a flow direction of the fluid flowing through the thermal management system flowpath 401. The second heat exchanger 412 is fluidly connected to the power electronics assembly 404 via a line 418. Line 418 defines, in part, the thermal management system flowpath 401. The power electronics assembly 404 is located downstream from the second heat exchanger 412 based on a flow direction of the fluid flowing through the thermal management system flowpath 401. The power electronics assembly 404 is fluidly connected to the electric machine 402 via a line 420. Line 420 defines, in part, the thermal management system flowpath 401. The electric machine 402 is located downstream from the power electronics assembly 404 based on a flow direction of the fluid flowing through the thermal management system flowpath 401. A line 422 defines, in part, the thermal management system flowpath 401 and is fluidly connected to the line 416 and the line 420.

A flow splitter 424 defines, in part, the thermal management system flowpath 401 and fluidly connects the line 422 with the line 416. The flow splitter 424 is located downstream from the first heat exchanger 410 and upstream of the second heat exchanger 412 based on a flow direction of the fluid flowing through the thermal management system flowpath 401. The flow splitter 424 is operable to split or divide the flow of the fluid flowing through the thermal management system flowpath 401 such that the fluid output from the first heat exchanger 410 is split or divided by the flow splitter 424 into a first portion 425 that flows to the second heat exchanger 412 via a remainder of the line 416 downstream of the flow splitter 424 and a second portion 427 that flows into the line 422. In exemplary embodiments, the flow splitter 424 may comprise a standard Y-type or T-type of fitting such that the flow splitter 424 is a passive flow splitter. As a passive flow splitter, normal operating pressure drops within the thermal management system flowpath 401 based on the components of the thermal management system 400 result in different volumes or portions of the fluid being divided between two different flowpaths. However, it should be understood that the flow splitter 424 may also comprise a flow control device 426 to actively regulate the flow of the fluid to the second heat exchanger 412 and the line 422. The flow control device 426 may comprise an electronically controlled valve or other type of device such that the flow of the fluid can be actively regulated based on, by way of non-limiting examples, power or thermal demand.

A flow joiner 428 defines, in part, the thermal management system flowpath 401 and fluidly connects the line 422 with the line 420. The flow joiner 428 is located downstream from the power electronics assembly 404 and upstream of the electric machine 402 based on a flow direction of the fluid flowing through the thermal management system flowpath 401. The flow joiner 428 is operable to join, merge, or combine flows of the fluid flowing through the thermal management system flowpath 401 such that the fluid output from the power electronics assembly 404 is joined or combined with fluid flowing through the line 422 at a location downstream from power electronics assembly 404. In the illustrated embodiment, the flow joiner 428 is operable to join or combine the first portion 425 of the flow of the fluid flowing through the thermal management system flowpath 401 with the second portion 427 of the flow of the fluid flowing through the thermal management system flowpath 401. Thus, the fluid output from the power electronics assembly 404 is joined or combined with fluid flowing through the line 422 at a location downstream from the power electronics assembly 404. In exemplary embodiments, the flow joiner 428 may comprise a standard Y-type or T-type of fitting such that the flow joiner 428 is a passive flow joiner. However, it should be understood that the flow joiner 428 may also comprise a flow control device 430 to actively regulate the combining of the fluid flows from the power electronics assembly 404 and the line 422. The flow control device 430 may comprise an electronically controlled valve or other type of device such that the flow of the fluid can be actively regulated based on, by way of non-limiting examples, power or thermal demand.

Thus, in exemplary embodiments, the thermal management system flowpath 401 defines a first flowpath loop 432 and a second flowpath loop 434. The first flowpath loop 432 is thermally connected to the first heat exchanger 410 and the electric machine 402. The second flowpath loop 434 is thermally connected to the first heat exchanger 410, the second heat exchanger 412, the power electronics assembly 404, and the electric machine 402. The first flowpath loop 432 includes the electric machine 402, the line 414, the first heat exchanger 410, a portion of the line 416 located upstream of the flow splitter 424, the flow splitter 424, the line 422, the flow joiner 428, and a portion of the line 420 located downstream from the flow joiner 428. The second flowpath loop 434 includes the electric machine 402, the line 414, the first heat exchanger 410, the line 416, the flow splitter 424, the second heat exchanger 412, the line 418, the power electronics assembly 404, and the line 420, and the flow joiner 428. In exemplary embodiments, the first flowpath loop 432 and the second flowpath loop 434 each comprise a respective closed fluid loop.

In operation, fluid flows downstream in the thermal management system flowpath 401 via line 414 to the first heat exchanger 410. In exemplary embodiments, the first heat exchanger 410 is an air-cooled heat exchanger. In exemplary embodiments, the thermal energy transfer fluid is oil. In such an embodiment, the first heat exchanger 410 may be an air-cooled oil cooler (ACOC). The fluid flows downstream and is output from the first heat exchanger 410 to the line 416. The fluid flows downstream in the thermal management system flowpath 401 via line 416 to the flow splitter 424. The flow splitter 424 separates, divides, or splits the flow into the first portion 425 flowing downstream in the thermal management system flowpath 401 to the second heat exchanger 412 and the second portion 427 flowing downstream in the thermal management system flowpath 401 to the line 422. In exemplary embodiments, the second heat exchanger 412 is a fuel-cooled heat exchanger. In exemplary embodiments, the thermal energy transfer fluid is oil. In such an embodiment, the second heat exchanger 412 is a fuel-cooled oil cooler (FCOC).

The first portion 425 of the fluid flows downstream in the thermal management system flowpath 401 via line 418 from the second heat exchanger 412 to the power electronics assembly 404. The first portion 425 of the fluid flows downstream in the thermal management system flowpath 401 via line 420 from the power electronics assembly 404 to the flow joiner 428. The second portion 427 of the fluid flows downstream in the thermal management system flowpath 401 via line 422 from the flow splitter 424 to the flow joiner 428. The flow joiner 428 combines the first portion 425 of the fluid flowing downstream in the thermal management system flowpath 401 via line 420 with the second portion 427 of the fluid flowing downstream in the thermal management system flowpath 401 via line 422, thereby resulting in a combined flow of the fluid flowing downstream in the thermal management system flowpath 401 via a remaining portion of the line 420 located downstream of the flow joiner 428 to the electric machine 402.

Thus, in operation, about 100% of the fluid flows via the thermal management system flowpath 401 through the electric machine 402 and the first heat exchanger 410. In exemplary embodiments, the flow splitter 424 causes less than 100% of the fluid to flow via the thermal management system flowpath 401 through the second heat exchanger 412 and the power electronics assembly 404. In other words, about 100% of the fluid flows via the first flowpath loop 432, and less than 100% of the fluid flows through a portion of the second flowpath loop 434 comprising the second heat exchanger 412 and the power electronics assembly 404. In exemplary embodiments, the first portion 425 of the fluid flowing via the thermal management system flowpath 401 is less than or equal to the second portion 427 of the fluid flowing via the thermal management system flowpath 401. In other words, in exemplary embodiments, the flow splitter 424 may cause 50% of the flow to be routed to the line 422 and 50% of the flow to be routed via the portion of the line 416 downstream of the flow splitter 424 to the second heat exchanger 412. It should be understood that the flow splitter 424 may cause other flow ratios to be split for the portion of the second flowpath loop 434 through the second heat exchanger 412 and the power electronics assembly 404. In exemplary embodiments, the flow ratio may be 90% of the flow routed to the line 422 and 10% of the flow routed via the portion of the line 416 downstream of the flow splitter 424 to the second heat exchanger 412. In exemplary embodiments, the flow ratio may be 60% of the flow routed to the line 422 and 40% of the flow routed via the portion of the line 416 downstream of the flow splitter 424 to the second heat exchanger 412. In exemplary embodiments, the flow ratio may be 70% of the flow routed to the line 422 and 30% of the flow routed via the portion of the line 416 downstream of the flow splitter 424 to the second heat exchanger 412. In exemplary embodiments, the flow ratio may be 65% of the flow routed to the line 422 and 35% of the flow routed via the portion of the line 416 downstream of the flow splitter 424 to the second heat exchanger 412. In exemplary embodiments, the flow ratio may be 64% of the flow routed to the line 422 and 36% of the flow routed via the portion of the line 416 downstream of the flow splitter 424 to the second heat exchanger 412. Thus, in exemplary embodiments, a smaller portion of the flow of the fluid flowing through the thermal management system flowpath 401 is flowed to the power electronics assembly 404 than is flowed to the electric machine 402. Also, the portion of the fluid flowing through the thermal management system flowpath 401 to the power electronics assembly 404 has flowed through at least two heat exchangers before reaching the power electronics assembly 404.

FIG. 4 is a simplified, schematic view of a thermal management system 500 in accordance with another exemplary aspect of the present disclosure. The exemplary thermal management system 500 of FIG. 4 may be incorporated into one or more of the gas turbine engines 210A, 210B and/or aircraft 100 described herein, or in any other suitable engine and/or aircraft.

Similar to the thermal management system 400 (FIG. 3), a thermal management system flowpath 501 is defined by thermal management system 500 and is a flowpath for a flow of a fluid that flows to, through, or both, the components of the thermal management system 500. The thermal management system 500 may be configured similarly to the thermal management system 400 of FIG. 3 including the power electronics assembly 404, the first heat exchanger 410, and the second heat exchanger 412 each thermally connected to the thermal management system flowpath 501. In the illustrated embodiment, the thermal management system 500 includes an electric machine 504, a fluid tank 506, and a pump assembly 508 each thermally connected to the thermal management system flowpath 501. The electric machine 504 may be configured similar to the electric machine 402 (FIG. 3) except the electric machine 504 may not have an integrated fluid tank, fluid pump, and fluid filter. Instead, the thermal management system 500 includes a distinctly located fluid tank 506 and pump assembly 508. In the illustrated embodiment, the pump assembly 508 includes a fluid pump 510 and a fluid filter 512. The fluid pump may 510 may be an electric pump or a mechanical pump. The electric machine 504 is electrically connected to the power electronics assembly 404. The first heat exchanger 410 is thermally connected to the electric machine 402. The second heat exchanger 412 is thermally connected to the first heat exchanger 410 and to the power electronics assembly 404.

In the illustrated embodiment, the first heat exchanger 410 is fluidly connected to the second heat exchanger 412 via a line 514. Line 514 defines, in part, the thermal management system flowpath 501. The second heat exchanger 412 is located downstream from the first heat exchanger 410 based on a flow direction of the fluid flowing through the thermal management system flowpath 501. The second heat exchanger 412 is fluidly connected to the power electronics assembly 404 via a line 516. Line 516 defines, in part, the thermal management system flowpath 501. The power electronics assembly 404 is located downstream from the second heat exchanger 412 based on a flow direction of the fluid flowing through the thermal management system flowpath 501. The power electronics assembly 404 is fluidly connected to the fluid tank 506 via a line 518. Line 518 defines, in part, the thermal management system flowpath 501. The fluid tank 506 is located downstream from the power electronics assembly 404 based on a flow direction of the fluid flowing through the thermal management system flowpath 501.

The fluid tank 506 is fluidly connected to the pump assembly 508 via a line 520. Line 520 defines, in part, the thermal management system flowpath 501. The pump assembly 508 is located downstream from the fluid tank 506 based on a flow direction of the fluid flowing through the thermal management system flowpath 501. The first heat exchanger 410 is fluidly connected to the pump assembly 508 via a line 522. Line 522 defines, in part, the thermal management system flowpath 501. The first heat exchanger 410 is located downstream from the pump assembly 508 based on a flow direction of the fluid flowing through the thermal management system flowpath 501.

A line 524 defines, in part, the thermal management system flowpath 501 and is fluidly connected to the electric machine 504. A line 526 also defines, in part, the thermal management system flowpath 501 and is fluidly connected to the electric machine 504. The thermal management system flowpath 501 also includes the flow splitter 424 and the flow joiner 428. The flow splitter 424 fluidly connects the line 524 with the line 514. The flow splitter 424 is located downstream from the first heat exchanger 410, upstream of the second heat exchanger 412, and upstream from the electric machine 504 based on a flow direction of the fluid flowing through the thermal management system flowpath 401. The flow splitter 424 is operable to split or divide the flow of the fluid flowing through the thermal management system flowpath 501 such that the fluid output from the first heat exchanger 410 is split or divided by the flow splitter 424 into a first portion 525 that flows to the second heat exchanger 412 via a remainder of the line 514 downstream of the flow splitter 424 and a second portion 427 that flows into the line 524. The flow splitter 424 may comprise a passive flow splitter or may comprise an active flow splitter such as the flow control device 426 (FIG. 3).

The flow joiner 428 fluidly connects the line 526 with the line 518. The flow joiner 428 is located downstream from the power electronics assembly 404, downstream of the electric machine 504, and upstream of the fluid tank 506 based on a flow direction of the fluid flowing through the thermal management system flowpath 501. The flow joiner 428 is operable to join or combine flows of the fluid flowing through the thermal management system flowpath 501 such that the fluid output from the power electronics assembly 404 is joined or combined with fluid flowing through the line 526 at a location downstream from the electric machine 504. In the illustrated embodiment, the flow joiner 428 is operable to join or combine the first portion 525 of the flow of the fluid flowing through the thermal management system flowpath 501 with the second portion 527 of the flow of the fluid flowing through the thermal management system flowpath 501. Thus, the fluid output from the power electronics assembly 404 (the first portion 525) is joined or combined with fluid flowing through the line 526 (the second portion 527) at a location downstream from the power electronics assembly 404. The flow joiner 428 may comprise a passive flow joiner or an active flow joiner, such as the flow control device 430 (FIG. 3).

Thus, in exemplary embodiments, the thermal management system flowpath 501 defines a first flowpath loop 532 and a second flowpath loop 534. The first flowpath loop 532 is thermally connected to the first heat exchanger 410, the electric machine 504, the fluid tank 506, and the pump assembly 508. The second flowpath loop 434 is thermally connected to the first heat exchanger 410, the second heat exchanger 412, the power electronics assembly 404, the fluid tank 506, and the pump assembly 508. The first flowpath loop 532 includes the first heat exchanger 410, a portion of the line 514 located upstream of the flow splitter 424, the flow splitter 424, the line 524, the electric machine 504, the line 526, the flow joiner 428, a portion of the line 518 located downstream from the flow joiner 428, the fluid tank 506, the line 520, the pump assembly 508, and the line 522. The second flowpath loop 534 includes the first heat exchanger 410, the line 514, the flow splitter 424, the second heat exchanger 412, the line 516, the power electronics assembly 404, the line 518, the flow joiner 428, the fluid tank 506, the line 520, the pump assembly 508, and the line 522. In exemplary embodiments, the first flowpath loop 432 and the second flowpath loop 434 each comprise a respective closed fluid loop.

In operation, fluid flows downstream in the thermal management system flowpath 501 via line 522 from the pump assembly 508 to the first heat exchanger 410. The fluid flows downstream in the thermal management system flowpath 501 and is output from the first heat exchanger 410 to the line 514. The fluid flows downstream in the thermal management system flowpath 501 via line 514 to the flow splitter 424. The flow splitter 424 separates, divides, or splits the flow into the first portion 525 flowing downstream in the thermal management system flowpath 501 to the second heat exchanger 412 and the second portion 527 flowing downstream in the thermal management system flowpath 501 to the line 524. The second portion 527 flows downstream in the thermal management system flowpath 501 along the line 524 to the electric machine 504.

The first portion 525 flows downstream in the thermal management system flowpath 501 along a portion of the line 514 located downstream from the flow splitter 424 to the second heat exchanger 412. The first portion 525 flows downstream in the thermal management system flowpath 501 and is output by the second heat exchanger 412 to the line 516, where the first portion 525 flows along the line 516 to the power electronics assembly 404. The first portion 525 flows downstream in the thermal management system flowpath 501 and is output by power electronics assembly 404 to the line 518. The first portion 525 flows downstream in the thermal management system flowpath 501 along the line 518 to the flow joiner 428. The second portion 527 flows downstream in the thermal management system flowpath 501 and is output by the electric machine 504 to the line 526. The second portion 527 flows downstream in the thermal management system flowpath 501 along the line 526 to the flow joiner 428. The flow joiner 428 joins or combines the first portion 525 with the second portion 527 and flows the combined fluid downstream in the thermal management system flowpath 501 to the fluid tank 506. The fluid flows downstream in the thermal management system flowpath 501 via line 520 from the fluid tank 506 to the pump assembly 508.

In exemplary embodiments, the flow splitter 424 may split or divide the flow of the fluid into the first portion 525 and the second portion 527 in similar ratios as the respective first and second portions 425 and 427 (FIG. 3) such that the volume or portion of the flow provided to the power electronics assembly 404 is equal to or less than the volume or portion of the flow provided to the electric machine 504. In exemplary embodiment, the flow provided to the power electronics assembly 404 passes through a greater number of heat exchangers than the flow provided to the electric machine 504.

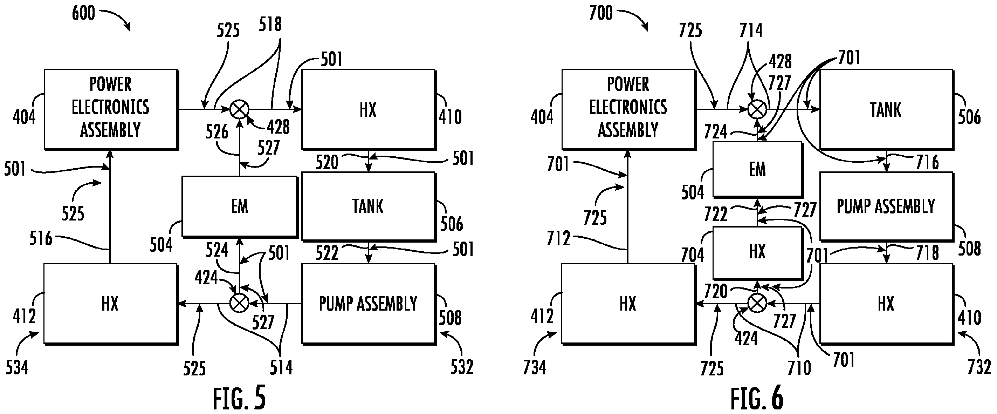

FIG. 5 is a simplified, schematic view of a thermal management system 600 in accordance with another exemplary aspect of the present disclosure. The exemplary thermal management system 600 of FIG. 5 may be incorporated into one or more of the gas turbine engines 210A, 210B and/or aircraft 100 described herein, or in any other suitable engine and/or aircraft. The thermal management system 600 is configured similarly to the thermal management system 500 (FIG. 4) defining the thermal management system flowpath 501 except that the fluid tank 506 and the pump assembly 508 are located downstream from the first heat exchanger 410. Thus, in the embodiment depicted in FIG. 5, the fluid tank 506 is a cold fluid tank 506 as the fluid flowing to the fluid tank 506 received at the fluid tank 506 via the line 520 from the first heat exchanger 410.

FIG. 6 is a simplified, schematic view of a thermal management system 700 in accordance with another exemplary aspect of the present disclosure. The exemplary thermal management system 700 of FIG. 6 may be incorporated into one or more of the gas turbine engines 210A, 210B and/or aircraft 100 described herein, or in any other suitable engine and/or aircraft.

Similar to the thermal management system 400 (FIG. 3), the thermal management system 500 (FIG. 4), and the thermal management system 600 (FIG. 5), a thermal management system flowpath 701 is defined by thermal management system 700 and is a flowpath for a flow of a fluid that flows to, through, or both, the components of the thermal management system 700. The thermal management system 700 may be configured similarly to the thermal management system 600 (FIG. 5) including the power electronics assembly 404, the first heat exchanger 410, the second heat exchanger 412, the fluid tank 506, the pump assembly 508, and the electric machine 504 each thermally connected to the thermal management system flowpath 701. The electric machine 504 is connected to the power electronics assembly 404. In the illustrated embodiment, the thermal management system 700 also includes a third heat exchanger 704 thermally connected to the thermal management system flowpath 701. The third heat exchanger 704 may be configured similarly to the first heat exchanger 410 or the second heat exchanger 412. The thermal management system 700 also includes the flow splitter 424 and the flow joiner 428 each thermally connected to the thermal management system flowpath 701.

In the illustrated embodiment, the first heat exchanger 410 is fluidly connected to the second heat exchanger 412 via a line 710. Line 710 defines, in part, the thermal management system flowpath 701. The second heat exchanger 412 is located downstream from the first heat exchanger 410 based on a flow direction of the fluid flowing through the thermal management system flowpath 701. The second heat exchanger 412 is fluidly connected to the power electronics assembly 404 via a line 712. Line 712 defines, in part, the thermal management system flowpath 701. The power electronics assembly 404 is located downstream from the second heat exchanger 412 based on a flow direction of the fluid flowing through the thermal management system flowpath 701. The power electronics assembly 404 is fluidly connected to the fluid tank 506 via a line 714. Line 718 defines, in part, the thermal management system flowpath 701. The fluid tank 506 is located downstream from the power electronics assembly 404 based on a flow direction of the fluid flowing through the thermal management system flowpath 701.

The fluid tank 506 is fluidly connected to the pump assembly 508 via a line 716. Line 716 defines, in part, the thermal management system flowpath 701. The pump assembly 508 is located downstream from the fluid tank 506 based on a flow direction of the fluid flowing through the thermal management system flowpath 701. The first heat exchanger 410 is fluidly connected to the pump assembly 508 via a line 718. Line 718 defines, in part, the thermal management system flowpath 701. The first heat exchanger 410 is located downstream from the pump assembly 508 based on a flow direction of the fluid flowing through the thermal management system flowpath 701.

A line 720 defines, in part, the thermal management system flowpath 701 and is fluidly connected to the third heat exchanger 704. The line 720 fluidly connects the third heat exchanger 704 to the flow splitter 424. The flow splitter 424 is located downstream from the first heat exchanger 410, the second heat exchanger 412 is located downstream from the flow splitter 424, and the third heat exchanger 704 is located downstream from the flow splitter 424, based on a flow direction of the fluid flowing through the thermal management system flowpath 701. The flow splitter 424 is operable to split or divide the flow of the fluid flowing through the thermal management system flowpath 701 such that the fluid output from the first heat exchanger 410 is split or divided by the flow splitter 424 into a first portion 725 that flows to the second heat exchanger 412 via a remainder of the line 710 downstream of the flow splitter 424 and a second portion 727 that flows into the line 720 and to the third heat exchanger 704. The flow splitter 424 may comprise a passive flow splitter or may comprise an active flow splitter such as the flow control device 426 (FIG. 3).

A line 722 defines, in part, the thermal management system flowpath 701 and is fluidly connected to the third heat exchanger 704. The line 722 fluidly connects the third heat exchanger 704 to the electric machine 504. The electric machine 504 is located downstream from the third heat exchanger 704 based on a flow direction of the fluid flowing through the thermal management system flowpath 701. A line 724 defines, in part, the thermal management system flowpath 701 and is fluidly connected to the electric machine 504. The line 724 fluidly connects the electric machine 504 to the and the flow joiner 428. The flow joiner 428 is located downstream from the electric machine 504 based on a flow direction of the fluid flowing through the thermal management system flowpath 701.

The flow joiner 428 fluidly connects the line 724 with the line 714. The flow joiner 428 is located downstream from the power electronics assembly 404, downstream of the electric machine 504, and upstream of the fluid tank 506 based on a flow direction of the fluid flowing through the thermal management system flowpath 701. The flow joiner 428 is operable to join or combine flows of the fluid flowing through the thermal management system flowpath 701 such that the fluid output from the power electronics assembly 404 is joined or combined with fluid flowing through the line 724 at a location downstream from the electric machine 504. In the illustrated embodiment, the flow joiner 428 is operable to join or combine the first portion 725 of the flow of the fluid flowing through the thermal management system flowpath 701 with the second portion 727 of the flow of the fluid flowing through the thermal management system flowpath 701. Thus, the fluid output from the power electronics assembly 404 (the first portion 725) is joined or combined with fluid flowing through the line 724 (the second portion 727) output from the electric machine 504. The flow joiner 428 may comprise a passive flow joiner or an active flow joiner, such as the flow control device 430 (FIG. 3).

Thus, in exemplary embodiments, the thermal management system flowpath 701 defines a first flowpath loop 732 and a second flowpath loop 734. The first flowpath loop 732 is thermally connected to the first heat exchanger 410, the third heat exchanger 704, the electric machine 504, the fluid tank 506, and the pump assembly 508. The second flowpath loop 734 is thermally connected to the first heat exchanger 410, the second heat exchanger 412, the power electronics assembly 404, the fluid tank 506, and the pump assembly 508. The first flowpath loop 432 includes the first heat exchanger 410, a portion of the line 710 located upstream of the flow splitter 424, the line 720, the third heat exchanger 704, the line 722, the electric machine 504, the line 724, the flow joiner 428, a portion of the line 714 located downstream from the flow joiner 428, the fluid tank 506, the line 716, the pump assembly 508, and the line 718. The second flowpath loop 734 includes the first heat exchanger 410, the line 710, the flow splitter 424, the second heat exchanger 412, the line 712, the power electronics assembly 404, the line 714, the flow joiner 428, the fluid tank 506, the line 716, the pump assembly 508, and the line 718. In exemplary embodiments, the first flowpath loop 732 and the second flowpath loop 734 each comprise a respective closed fluid loop.

In operation, fluid flows downstream in the thermal management system flowpath 701 via line 718 from the pump assembly 508 to the first heat exchanger 410. The fluid flows downstream in the thermal management system flowpath 701 and is output from the first heat exchanger 410 to the line 710. The fluid flows downstream in the thermal management system flowpath 701 via line 710 to the flow splitter 424. The flow splitter 424 separates, divides, or splits the flow into the first portion 725 flowing downstream in the thermal management system flowpath 701 to the second heat exchanger 412 and the second portion 727 flowing downstream in the thermal management system flowpath 701 to the line 720. The second portion 727 flows downstream in the thermal management system flowpath 701 via the line 720 to the third heat exchanger 704.

The first portion 525 flows downstream in the thermal management system flowpath 701 along a portion of the line 710 located downstream from the flow splitter 424 to the second heat exchanger 412. The first portion 525 flows downstream in the thermal management system flowpath 701 and is output by the second heat exchanger 412 to the line 712, where the first portion 525 flows along the line 712 to the power electronics assembly 404. The first portion 525 flows downstream in the thermal management system flowpath 701 and is output by power electronics assembly 404 to the line 714. The first portion 525 flows downstream in the thermal management system flowpath 701 along the line 714 to the flow joiner 428.

The second portion 527 flows downstream in the thermal management system flowpath 701 and is output from the third heat exchanger 704 to the line 722. The second portion 527 flows downstream in the thermal management system flowpath 701 along the line 722 to the electric machine 504. The second portion 527 flows downstream in the thermal management system flowpath 701 and is output by the electric machine 504 to the line 724. The second portion 527 flows downstream in the thermal management system flowpath 701 along the line 724 to the flow joiner 428. The flow joiner 428 joins or combines the first portion 525 with the second portion 527 and flows the combined fluid downstream in the thermal management system flowpath 701 to the fluid tank 506. The fluid flows downstream in the thermal management system flowpath 701 via line 716 from the fluid tank 506 to the pump assembly 508.

In exemplary embodiments, the flow splitter 424 may split or divide the flow of the fluid into the first portion 725 and the second portion 727 in similar ratios as the respective first and second portions 425 and 427 (FIG. 3) such that the volume or portion of the flow provided to the power electronics assembly 404 is equal to or less than the volume or portion of the flow provided to the electric machine 504.

Thus, in exemplary embodiments, a separate thermal management system 400, 500, 600, or 700 as depicted in FIGS. 3-6 may be used for one or more electric machines. For example, considering the thermal management system 400 (FIG. 3), there may be one thermal management system 400 for a HP electric machine and one thermal management system 400 for a LP electric machine. Thus, in exemplary embodiments, there is a thermal management system flowpath 401 for the HP electric machine and a separate thermal management system flowpath 401 for the LP electric machine (i.e., separate fluid loops - one for the HP electric machine and one for the LP electric machine). However, it should be understood that each thermal management system flowpath 401 may share a particular heat exchanger. For example, the thermal management system flowpath 401 for the HP electric machine and the thermal management system flowpath 401 for the LP electric machine may use the same heat exchanger (e.g., a FCOC) to provide thermal energy transfer for their respective fluid loops.

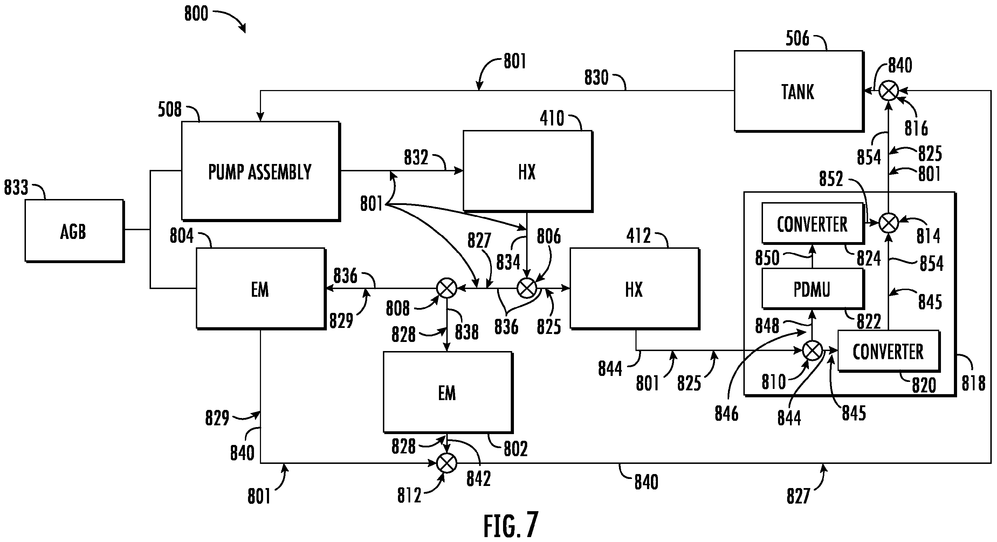

FIG. 7 is a simplified, schematic view of a thermal management system 800 in accordance with another exemplary aspect of the present disclosure. The exemplary thermal management system 800 of FIG. 7 may be incorporated into one or more of the gas turbine engines 210A, 210B and/or aircraft 100 described herein, or in any other suitable engine and/or aircraft.

Similar to the thermal management system 400 (FIG. 3), the thermal management system 500 (FIG. 4), the thermal management system 600 (FIG. 5), and the thermal management system 700 (FIG. 6), a thermal management system flowpath 801 is defined by thermal management system 800 and is a flowpath for a flow of a fluid that flows to, through, or both, the components of the thermal management system 800. The thermal management system 800 may be configured similarly to the thermal management system 600 (FIG. 5) including the first heat exchanger 410, the second heat exchanger 412, the fluid tank 506, and the pump assembly 508, each thermally connected to the thermal management system flowpath 801. In the illustrated embodiment, the thermal management system 800 includes a first electric machine 802 and a second electric machine 804 each thermally connected to the thermal management system flowpath 801. The first electric machine 802 may be an LP electric machine, and the second electric machine 804 may be an HP electric machine. In exemplary embodiments, the first heat exchanger 410 may be an air-cooled heat exchanger, and the second heat exchanger 412 may be a fuel-cooled heat exchanger. Thus, in an exemplary embodiment where the thermal energy transfer fluid is oil, the first heat exchanger 410 may be an ACOC, and the second heat exchanger 412 may be a FCOC. The thermal management system 700 also includes flow splitters 806, 808, and 810 and flow joiners 812, 814, and 816 each thermally connected to, and define in part, the thermal management system flowpath 801. Each of the flow splitters 806, 808, and 810 may be configured similarly to the flow splitter 424 (FIG. 3), and each of the flow joiners 812, 814, and 816 may be configured similarly to the flow joiner 428 (FIG. 3). Thus, one or more of the flow splitters 806, 808, and 810 may be configured as passive flow splitters or active flow splitters, and one or more of the flow joiners 812, 814, and 816 may be configured as passive flow joiners or active flow joiners.

In the illustrated embodiment, the thermal management system 800 includes a power electronics assembly 818 thermally connected to the thermal management system flowpath 801. The power electronics assembly 818 may be configured similarly to the power electronics assembly 404 (FIGS. 3-6) and may comprise one or more power converters, one or more PDMUs, or both, electrically connected to the first electric machine 802, the second electric machine 804, or both. In exemplary embodiments, the power electronics assembly 818 includes a power converter 820 thermally connected to the thermal management system flowpath 801. In exemplary embodiments, the power converter 820 is connected to the first electric machine 802. Accordingly, if the first electric machine 802 is a LP electric machine, the power converter 820 may be connected to an LP electric machine. In the illustrated embodiment, the power electronics assembly 818 includes a PDMU 822 and a power converter 824 each thermally connected to the thermal management system flowpath 801. In exemplary embodiments, the PDMU 822 and the power converter 824 are connected to the second electric machine 804. Accordingly, if the second electric machine 804 is a HP electric machine, the PDMU 822 and the power converter 824 may be connected to an HP electric machine.

In the illustrated embodiment, the fluid tank 506 is fluidly connected to the pump assembly 508 via a line 830. Line 830 defines, in part, the thermal management system flowpath 801. The pump assembly 508 is located downstream from the fluid tank 506 based on a flow direction of the fluid flowing through the thermal management system flowpath 801. The pump assembly 508 is fluidly connected to the first heat exchanger 410 via a line 832. Line 832 defines, in part, the thermal management system flowpath 801. The first heat exchanger 410 is located downstream from the pump assembly 508 based on a flow direction of the fluid flowing through the thermal management system flowpath 801.

In the illustrated embodiment, the thermal management system 800 includes an accessory gear box (AGB) 833 for provisioning rotational energy or power to the pump assembly 508, the second electric machine 804, or both. The AGB 833 may be connected to the pump assembly 508, the second electric machine 804, or both, using a gear box splitter mechanism or a common or single drive shaft. It should also be understood that the pump assembly 508 may be integrated as part of the second electric machine 804 and be driven by the AGB 833.

A line 834 is fluidly connected to the first heat exchanger 410 and the flow splitter 806. Line 834 defines, in part, the thermal management system flowpath 801. The flow splitter 806 is located downstream from the first heat exchanger 410 based on a flow direction of the fluid flowing through the thermal management system flowpath 801. A line 836 is fluidly connected to the flow splitter 806, the second heat exchanger 412, the flow splitter 808, and the second electric machine 804. Line 836 defines, in part, the thermal management system flowpath 801. The flow splitter 806 splits, divides, or separates the flow output from the first heat exchanger 410 into a first portion 825 and a second portion 827. The first portion 825 flows along a portion of the line 836 downstream from the flow splitter 806 to the second heat exchanger 412. The second portion 827 flows along a portion of the line 836 downstream from the flow splitter 806 to the flow splitter 808. The flow splitter 808 splits, divides, or separates the flow output from the flow splitter 806 (i.e., the second portion 827) into a third portion 828 and a fourth portion 829.

A line 838 is fluidly connected to the flow splitter 808 and the first electric machine 802. Line 838 defines, in part, the thermal management system flowpath 801. The third portion 828 flows downstream from the flow splitter 808 to the first electric machine 802 via the line 838 based on a flow direction of the fluid flowing through the thermal management system flowpath 801. The fourth portion 829 flows along a portion of the line 836 downstream from the flow splitter 808 to the second electric machine 804 based on a flow direction of the fluid flowing through the thermal management system flowpath 801.

A line 840 is fluidly connected to the second electric machine 804, the flow joiner 812, the flow joiner 816, and the fluid tank 506. Line 840 defines, in part, the thermal management system flowpath 801. The fourth portion 829 flows downstream via the line 840 from the second electric machine 804 to the flow joiner 812 based on a flow direction of the fluid flowing through the thermal management system flowpath 801. A line 842 is fluidly connected to the first electric machine 802 and the flow joiner 812. Line 842 defines, in part, the thermal management system flowpath 801. The third portion 828 flows downstream via the line 842 from the first electric machine 802 to the flow joiner 812 based on a flow direction of the fluid flowing through the thermal management system flowpath 801. The flow joiner 812 joins or combines the third and fourth portions 828 and 829 and flows the combined flow, essentially reforming the second portion 827, via the line 840 to the flow joiner 816.

The second heat exchanger 412 is fluidly connected to the power electronics assembly 818 via a line 844. Line 844 defines, in part, the thermal management system flowpath 801. The line 844 is thermally connected to the second heat exchanger 412, the flow splitter 810, and the power converter 820. The first portion 825 of the fluid flows via the line 844 from the second heat exchanger 412 to the flow splitter 810 based on a flow direction of the fluid flowing through the thermal management system flowpath 801. A line 848 is fluidly connected to the flow splitter 810 and the PDMU 822. Line 848 defines, in part, the thermal management system flowpath 801. The flow splitter 810 splits, divides, or separates the flow output from the second heat exchanger 412 (i.e., the first portion 825) into a fifth portion 845 and a sixth portion 846. The fifth portion 845 flows downstream via a portion of the line 844 located downstream of the flow splitter 810 to the power converter 820 based on a flow direction of the fluid flowing through the thermal management system flowpath 801. The sixth portion 846 flows downstream via the line 848 to the PDMU 822 based on a flow direction of the fluid flowing through the thermal management system flowpath 801.

A line 850 is fluidly connected to the PDMU 822 and the power converter 824. A line 852 is fluidly connected to the power converter 824 and the flow joiner 814. A line 854 is fluidly connected to the power converter 820, the flow joiner 814, and the flow joiner 816. Lines 850, 852, and 854 each define, in part, the thermal management system flowpath 801. The sixth portion 846 flows downstream via the line 850 from the PDMU 822 to the power converter 824 based on a flow direction of the fluid flowing through the thermal management system flowpath 801. The sixth portion 846 flows downstream via the line 852 from the power converter 824 to the flow joiner 814 based on a flow direction of the fluid flowing through the thermal management system flowpath 801. The fifth portion 845 flows downstream via the line 854 from the power converter 820 to the flow joiner 814 based on a flow direction of the fluid flowing through the thermal management system flowpath 801.

The flow joiner 814 joins or combines the fifth portion 845 with the sixth portion 846 and flows the combined fluid, essentially reforming the first portion 825, via a portion of the line 854 located downstream of the flow joiner 814 to the flow joiner 816 based on a flow direction of the fluid flowing through the thermal management system flowpath 801, where it is joined or combined with the fourth portion 829. The combined fluid flows downstream from the flow joiner 816 via a portion of the line 840 located downstream of the flow joiner 816 to the fluid tank 506 based on a flow direction of the fluid flowing through the thermal management system flowpath 801.

Thus, in exemplary embodiments, the thermal management system flowpath 801 forms a closed fluid loop that provides thermal energy management to one or more electric machines and one or more power electronics assemblies connected to the one or more electric machines. Part of the fluid flowing via thermal management system flowpath 801 is used to cool the one or more electric machines, and another part of the fluid flowing via thermal management system flowpath 801 is used to cool the power converters and PDMUs connected to the one or more electric machines.

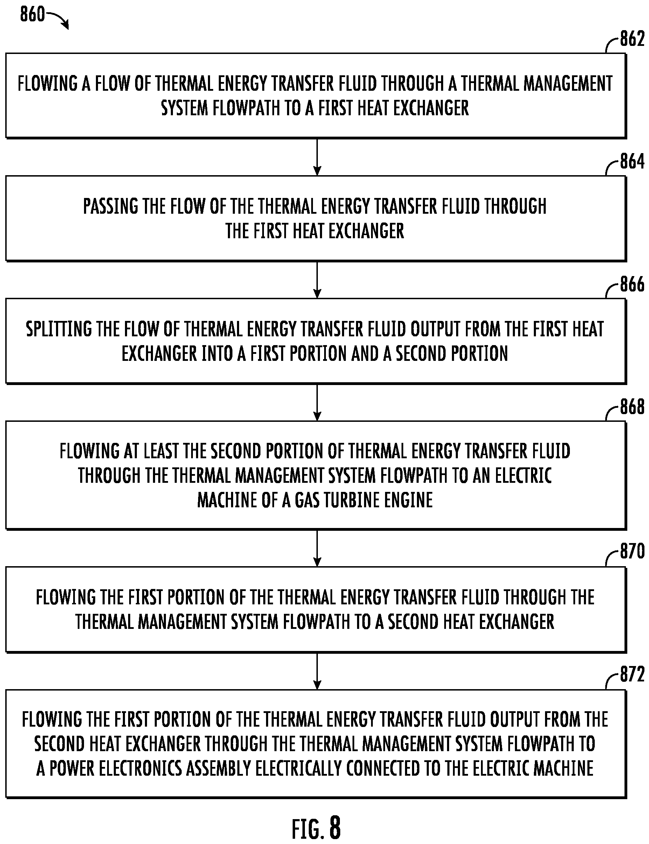

Referring to FIG. 8, a block diagram depicting an exemplary method 860 for thermal management for an aeronautical power system is provided. The method 860 begins at 862, where a flow of a thermal energy transfer fluid is flowed through a thermal management system flowpath 401 to a first heat exchanger 410. At 864, the flow of the thermal energy transfer fluid is passed through the first heat exchanger 410. At 866, the flow of the thermal energy transfer fluid output from the first heat exchanger 410 is split into a first portion 425 and a second portion 427. At 868, at least the second portion 427 of the thermal energy transfer fluid is flowed through the thermal management system flowpath 401 to the electric machine 402 of a gas turbine engine. At 870, the first portion 425 of the thermal energy transfer fluid is flowed through the thermal management system flowpath 401 to the second heat exchanger 412. At 872, the first portion 425 of the thermal energy transfer fluid output from the second heat exchanger 412 is flowed through the thermal management system flowpath 401 to the power electronics assembly 404 electrically connected to the electric machine 402.

FIG. 9 provides an example computing system 900 according to example embodiments of the present disclosure. The computing devices or elements described herein, such as PDMUs 408 and 822, may include various components and perform various functions of the computing system 900 described below, for example.

As shown in FIG. 9, the computing system 900 can include one or more computing device(s) 902. The computing device(s) 902 can include one or more processor(s) 902A and one or more memory device(s) 902B. The one or more processor(s) 902A can include any suitable processing device, such as a microprocessor, microcontroller, integrated circuit, logic device, and/or other suitable processing device. The one or more memory device(s) 902B can include one or more computer-executable or computer-readable media, including, but not limited to, non-transitory computer-readable media, RAM, ROM, hard drives, flash drives, and/or other memory devices.

The one or more memory device(s) 902B can store information accessible by the one or more processor(s) 902A, including computer-readable instructions 902C that can be executed by the one or more processor(s) 902A. The computer-readable instructions 902C can be any set of instructions that when executed by the one or more processor(s) 902A, cause the one or more processor(s) 902A to perform operations. In some embodiments, the computer-readable instructions 902C can be executed by the one or more processor(s) 902A to cause the one or more processor(s) 902A to perform operations, such as any of the operations and functions for which the computing system 900 and/or the computing device(s) 902 are configured, such as controlling operation of electrical power systems or the power electronics assemblies, the electric machines, and the one or more flow control devices 426 and 430. The computer-readable instructions 902C can be software written in any suitable programming language or can be implemented in hardware. Additionally, and/or alternatively, the computer-readable instructions 902C can be executed in logically and/or virtually separate threads on processor(s) 902A. The memory device(s) 902B can further store data 902D that can be accessed by the processor(s) 902A. For example, the data 902D can include models, lookup tables, databases, etc.

The computing device(s) 902 can also include a network interface 902E used to communicate, for example, with the other components of the computing system 900 (e.g., via a communication network). The network interface 902E can include any suitable components for interfacing with one or more network(s), including for example, transmitters, receivers, ports, controllers, antennas, and/or other suitable components. One or more devices can be configured to receive one or more commands from the computing device(s) 902 or provide one or more commands to the computing device(s) 902.

The technology discussed herein makes reference to computer-based systems and actions taken by and information sent to and from computer-based systems. One of ordinary skill in the art will recognize that the inherent flexibility of computer-based systems allows for a great variety of possible configurations, combinations, and divisions of tasks and functionality between and among components. For instance, processes discussed herein can be implemented using a single computing device or multiple computing devices working in combination. Databases, memory, instructions, and applications can be implemented on a single system or distributed across multiple systems. Distributed components can operate sequentially or in parallel.

Thus, the present disclosure provides a thermal management system tailored to meet the thermal needs of the LP and HP electric machines and the power distribution components associated with the LP and HP electric machines. The present disclosure provides dedicated or separate cooling loops for the hybrid electric systems. Each cooling loop provides thermal management for the LP and HP electric machines and the power converter and distribution electronic assemblies associated with the LP and HP electric machines to meet the unique thermal requirements of the foregoing. In exemplary embodiments, these cooling loops are separate from other engine cooling loops and include both the electric machine and the power electronics assemblies electrically connected to the electric machine. In exemplary embodiments, for the LP electric machine loop, heat exchange fluid is pumped from a tank to a heat exchanger, and then to a flow splitter. A portion of the post-flow splitter heat exchange fluid is flowed to the LP electric machine, and a remaining portion is flowed to another heat exchanger for a cooling boost before flowing to the power electronics assembly. Spent heat exchange fluids from the LP electric machine and the power electronics assembly meet and are joined to return to the tank. An HP electric machine loop may be configured similarly to the LP electric machine loop, but a generator assembly of the HP electric machine may include a tank and a pump so that the HP electric machine is cooled by ACOC oil with spent oil from the power electronics assembly.

Further aspects are provided by the subject matter of the following clauses:

A propulsion system comprising: a power electronics assembly electrically connected to the electric machine; and a thermal management system defining a thermal management system flowpath and operable to provide a flow of a fluid to the electric machine and the power electronics assembly through the thermal management system flowpath, the thermal management system comprising: a first heat exchanger thermally connected to the thermal management system flowpath and to the electric machine; and a second heat exchanger thermally connected to the thermal management system flowpath downstream of the first heat exchanger, the second heat exchanger connected to the power electronics assembly.

The propulsion system of the preceding clause, wherein the thermal management system flowpath comprises a flow splitter downstream of the first heat exchanger, the flow splitter separating the flow of the fluid into a first portion of the flow of the fluid and a second portion of the flow of the fluid, the flow splitter diverting the first portion of the flow of the fluid to the second heat exchanger, and wherein at least the second portion of the flow of the fluid flows to the electric machine.

The propulsion system of any preceding clause, wherein the first portion is equal to or less than the second portion.

The propulsion system of any preceding clause, wherein the thermal management system flowpath comprises a flow joiner positioned downstream of the power converter system, the flow joiner combining the first portion of the flow of the fluid with the second portion of the flow of the fluid.

The propulsion system of any preceding clause, wherein the thermal management system flowpath comprises a flow control device regulating the flow of the fluid to the second heat exchanger.

The propulsion system of any preceding clause, wherein the electric machine comprises one or more of a fluid tank, a fluid pump, or a fluid filter.

The propulsion system of any preceding clause, wherein the first heat exchanger comprises an air-cooled heat exchanger.

The propulsion system of any preceding clause, wherein the second heat exchanger comprises a fuel-cooled heat exchanger.

The propulsion system of any preceding clause, wherein the fluid comprises at least one of oil, carbon dioxide, nitrogen, helium, or xenon.

The propulsion system of any preceding clause, wherein the fluid comprises oil, and wherein the first heat exchanger comprises an air-cooled oil cooler, and wherein the second heat exchanger comprises a fuel-cooled oil cooler.

The propulsion system of any preceding clause, further comprising a gas turbine engine comprising a compressor section, a combustion section, and a turbine section in serial flow order, wherein the electric machine is configured to provide power to the gas turbine engine.

The propulsion system of any preceding clause, further comprising a gas turbine engine comprising a high pressure system and a low pressure system, and wherein the electric machine is coupled to one of the high pressure system or the low pressure system.

The propulsion system of any preceding clause, further comprising a computing system configured to control operation of at least one of the electric machine, the power electronics assembly, or the flow control device.

A method for thermal management for an aircraft, the method comprising: flowing a flow of a fluid through a thermal management system flowpath to a first heat exchanger thermally connected to the thermal management system flowpath; passing the flow of the fluid through the first heat exchanger; splitting the flow of the fluid from the first heat exchanger into a first portion of the flow of the fluid and a second portion of the flow of the fluid; flowing at least the second portion of the flow of the fluid through the thermal management system flowpath to an electric machine of a gas turbine engine, the electric machine thermally connected to the thermal management system flowpath; flowing the first portion of the flow of the fluid through the thermal management system flowpath to a second heat exchanger thermally connected to the thermal management system flowpath; and flowing the first portion of the flow of the fluid from the second heat exchanger through the thermal management system flowpath to a power electronics assembly electrically connected to the electric machine, the power electronics assembly thermally connected to the thermal management system flowpath.

The method of any preceding clause, further comprising splitting the flow of the fluid from the first heat exchanger so that the first portion is equal to or less than the second portion.

The method of any preceding clause, wherein the fluid comprises oil, and wherein flowing the flow of the fluid through the thermal management system flowpath to the first heat exchanger comprises flowing the flow of the oil through the thermal management system flowpath to an air-cooled oil cooler.

The method of any preceding clause, wherein the fluid comprises oil, and wherein flowing the second portion of the flow of the fluid from the first heat exchanger through the thermal management system flowpath to the second heat exchanger comprises flowing the second portion of the flow of the oil from the first heat exchanger through the thermal management system flowpath to a fuel-cooled oil cooler.

The method of any preceding clause, further comprising: combining the first portion of the flow of the fluid with the second portion of the flow of the fluid downstream from the power electronics assembly to form a combined flow of the fluid; and flowing the combined flow of the fluid through the thermal management system flowpath to the electric machine.

The method of any preceding clause, further comprising: combining the first portion of the flow of the fluid with the second portion of the flow of the fluid downstream of the power electronics assembly to form a combined flow of the fluid; and flowing the combined flow of the fluid through the thermal management system flowpath to the first heat exchanger.

A propulsion system comprising: a thermal management system defining a thermal management system flowpath and operable to provide a flow of a fluid to an electric machine and a power converter system through the thermal management system flowpath, the power electronics assembly electrically connected to the electric machine, the thermal management system flowpath defining: a first flowpath loop thermally connected to a first heat exchanger and the electric machine; and a second flowpath loop thermally connected to the first exchanger, a second heat exchanger downstream from the first heat exchanger, and the power electronics assembly.

The propulsion system of any preceding clause, further comprising a flow splitter thermally connected to the first flowpath loop and the second flowpath loop downstream of the first heat exchanger, the flow splitter diverting a portion of the flow of the fluid into the second flowpath loop.

The propulsion system of any preceding clause, further comprising a flow joiner thermally connected to the first flowpath loop and the second flowpath loop located downstream of the power electronics assembly, the flow joiner combining the portion of the flow of the fluid flowing through the second flowpath loop with another portion of the flow of the fluid flowing through the first flowpath loop.

The propulsion system of any preceding clause, wherein the fluid comprises oil, and wherein the first heat exchanger comprises an air-cooled oil cooler, and wherein the second heat exchanger comprises a fuel-cooled oil cooler.

An aircraft, comprising: a hybrid-electric propulsion system comprising: a gas turbine engine comprising a high pressure system and a low pressure system; an electric machine coupled to one of the high pressure system or the low pressure system; and a power electronics assembly electrically connected to the electric machine; a thermal management system defining a thermal management system flowpath and operable to provide a flow of a fluid to the electric machine and the power electronics assembly through the thermal management system flowpath, the thermal management system comprising: a first heat exchanger thermally connected to the thermal management system flowpath and to the electric machine; and a second heat exchanger thermally connected to the thermal management system flowpath downstream of the first heat exchanger, the second heat exchanger thermally connected to the power electronics assembly.

A non-transitory computer-readable medium comprising computer-executable instructions, which when executed by a processor associated with an electronic controller cause the electronic controller to perform a method for thermal management for a hybrid-electric propulsion system of an aircraft, the hybrid-electric propulsion system comprising a gas turbine engine having a high pressure system, a low pressure system, and an electric machine coupled to one of the high pressure system or low pressure system, the method comprising: flowing a flow of a fluid through a thermal management system flowpath to a first heat exchanger thermally connected to the thermal management system flowpath; passing the flow of the fluid through the first heat exchanger; splitting the flow of the fluid from the first heat exchanger into a first portion of the flow of the fluid and a second portion of the flow of the fluid; flowing at least the second portion of the flow of the fluid through the thermal management system flowpath to the electric machine, the electric machine thermally connected to the thermal management system flowpath; flowing the first portion of the flow of the fluid through the thermal management system flowpath to a second heat exchanger thermally connected to the thermal management system flowpath; and flowing the first portion of the flow of the fluid from the second heat exchanger through the thermal management system flowpath to a power electronics assembly electrically connected to the electric machine, the power electronics assembly thermally connected to the thermal management system flowpath.

A propulsion system comprising: a thermal management system defining a thermal management system flowpath and operable to provide a flow of a fluid to an electric machine and a power electronics assembly through the thermal management system flowpath, the power electronics assembly electrically connected to the electric machine, the thermal management system comprising: a first heat exchanger thermally connected to the thermal management system flowpath and to the electric machine; and a second heat exchanger thermally connected to the thermal management system flowpath downstream of the first heat exchanger, the second heat exchanger thermally connected to the power electronics assembly.

The propulsion system of any preceding clause, wherein the thermal management system flowpath comprises a flow splitter downstream of the first heat exchanger, the flow splitter separating the flow of the fluid into a first portion of the flow of the fluid and a second portion of the flow of the fluid, the flow splitter diverting the first portion of the flow of the fluid to the second heat exchanger, and wherein at least the second portion of the flow of the fluid flows to the electric machine.

The propulsion system of any preceding clause, wherein the first portion is equal to or less than the second portion.

The propulsion system of any preceding clause, wherein the thermal management system flowpath comprises a flow joiner positioned downstream of the power electronics assembly, the flow joiner combining the first portion of the flow of the fluid with the second portion of the flow of the fluid.

The propulsion system of any preceding clause, wherein the thermal management system flowpath comprises a flow control device regulating the flow of the fluid to the second heat exchanger.

The propulsion system of any preceding clause, wherein the electric machine comprises one or more of a fluid tank, a fluid pump, or a fluid filter.

The propulsion system of any preceding clause, wherein the first heat exchanger comprises an air-cooled heat exchanger.

The propulsion system of any preceding clause, wherein the second heat exchanger comprises a fuel-cooled heat exchanger.

The propulsion system of any preceding clause, wherein the fluid comprises at least one of oil, carbon dioxide, nitrogen, helium, or xenon.

The propulsion system of any preceding clause, wherein the fluid comprises oil, and wherein the first heat exchanger comprises an air-cooled oil cooler, and wherein the second heat exchanger comprises a fuel-cooled oil cooler.

A method for thermal management for an aircraft, the method comprising: flowing a flow of a fluid through a thermal management system flowpath to a first heat exchanger thermally connected to the thermal management system flowpath; passing the flow of the fluid through the first heat exchanger; splitting the flow of the fluid from the first heat exchanger into a first portion of the flow of the fluid and a second portion of the flow of the fluid; flowing at least the second portion of the flow of the fluid through the thermal management system flowpath to an electric machine of a gas turbine engine, the electric machine thermally connected to the thermal management system flowpath; flowing the first portion of the flow of the fluid through the thermal management system flowpath to a second heat exchanger thermally connected to the thermal management system flowpath; and flowing the first portion of the flow of the fluid from the second heat exchanger through the thermal management system flowpath to a power electronics assembly electrically connected to the electric machine, the power electronics assembly thermally connected to the thermal management system flowpath.

The method of any preceding clause, further comprising splitting the flow of the fluid from the first heat exchanger so that the first portion is equal to or less than the second portion.

The method of any preceding clause, wherein the fluid comprises oil, and wherein flowing the flow of the fluid through the thermal management system flowpath to the first heat exchanger comprises flowing the flow of the oil through the thermal management system flowpath to an air-cooled oil cooler.

The method of any preceding clause, wherein the fluid comprises oil, and wherein flowing the second portion of the flow of the fluid from the first heat exchanger through the thermal management system flowpath to the second heat exchanger comprises flowing the second portion of the flow of the oil from the first heat exchanger through the thermal management system flowpath to a fuel-cooled oil cooler.

The method of any preceding clause, further comprising: combining the first portion of the flow of the fluid with the second portion of the flow of the fluid downstream from the power electronics assembly to form a combined flow of the fluid; and flowing the combined flow of the fluid through the thermal management system flowpath to the electric machine.

The method of any preceding clause, further comprising: combining the first portion of the flow of the fluid with the second portion of the flow of the fluid downstream of the power electronics assembly to form a combined flow of the fluid; and flowing the combined flow of the fluid through the thermal management system flowpath to the first heat exchanger.

A propulsion system comprising: a thermal management system defining a thermal management system flowpath and operable to provide a flow of a fluid to an electric machine and a power electronics assembly through the thermal management system flowpath, the power electronics assembly electrically connected to the electric machine, the thermal management system flowpath defining: a first flowpath loop thermally connected to a first heat exchanger and the electric machine; and a second flowpath loop thermally connected to the first heat exchanger, a second heat exchanger downstream from the first heat exchanger, and the power electronics assembly.

The propulsion system of any preceding clause, further comprising a flow splitter thermally connected to the first flowpath loop and the second flowpath loop downstream of the first heat exchanger, the flow splitter diverting a portion of the flow of the fluid into the second flowpath loop.

The propulsion system of any preceding clause, further comprising a flow joiner thermally connected to the first flowpath loop and the second flowpath loop located downstream of the power electronics assembly, the flow joiner combining the portion of the flow of the fluid flowing through the second flowpath loop with another portion of the flow of the fluid flowing through the first flowpath loop.

The propulsion system of any preceding clause, wherein the fluid comprises oil, and wherein the first heat exchanger comprises an air-cooled oil cooler, and wherein the second heat exchanger comprises a fuel-cooled oil cooler.

This written description uses examples to disclose the present disclosure, including the best mode, and also to enable any person skilled in the art to practice the disclosure, including making and using any devices or systems and performing any incorporated methods. The patentable scope of the disclosure is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. A propulsion system (150) comprising:
a thermal management system (400, 500, 600, 700, 800) defining a thermal management system flowpath (401, 501, 701, 801) and operable to provide a flow of a fluid to an electric machine (300A, 300B, 302A, 402, 504, 802, 804) and a power electronics assembly (404, 818) through the thermal management system flowpath (401, 501, 701, 801), the power electronics assembly (404, 818) electrically connected to the electric machine (300A, 300B, 302A, 402, 504, 802, 804), the thermal management system (400, 500, 600, 700, 800) comprising:
a first heat exchanger (410) thermally connected to the thermal management system flowpath (401, 501, 701, 801) and to the electric machine (300A, 300B, 302A, 402, 504, 802, 804); and
a second heat exchanger (412) thermally connected to the thermal management system flowpath (401, 501, 701, 801) downstream of the first heat exchanger (410), the second heat exchanger (412) connected to the power electronics assembly (404, 818).

2. The propulsion system (150) of claim 1, wherein the thermal management system flowpath (401, 501, 701, 801) comprises a flow splitter (424, 806) downstream of the first heat exchanger (410), the flow splitter (424, 806) separating the flow of the fluid into a first portion (425, 525, 725, 825) of the flow of the fluid and a second portion (427, 527, 727, 827) of the flow of the fluid, the flow splitter (424, 806) diverting the first portion (425, 525, 725, 825) of the flow of the fluid to the second heat exchanger (412), and wherein at least the second portion (427, 527, 727, 827) of the flow of the fluid flows to the electric machine (300A, 300B, 302A, 402, 504, 802, 804).

3. The propulsion system (150) of claim 2, wherein the first portion (425, 525, 725, 825) is equal to or less than the second portion (427, 527, 727, 827).

4. The propulsion system (150) of claim 2 or 3, wherein the thermal management system flowpath (401, 501, 701, 801) comprises a flow joiner (428, 816) positioned downstream of the power electronics assembly (404, 818), the flow joiner (428, 816) combining the first portion (425, 525, 725, 825) of the flow of the fluid with the second portion (427, 527, 727, 827) of the flow of the fluid.

5. The propulsion system (150) of any preceding claim, wherein the thermal management system flowpath (401, 501, 701, 801) comprises a flow control device (426) regulating the flow of the fluid to the second heat exchanger (412).

6. The propulsion system (150) of any preceding claim, wherein the electric machine (300A, 300B, 302A, 402, 504, 802, 804) comprises one or more of a fluid tank (506), a fluid pump (510), or a fluid filter (512).

7. The propulsion system (150) of any preceding claim, wherein the first heat exchanger (410) comprises an air-cooled heat exchanger (410).

8. The propulsion system (150) of any preceding claim, wherein the second heat exchanger (412) comprises a fuel-cooled heat exchanger (412).

9. The propulsion system (150) of any preceding claim, wherein the fluid comprises at least one of oil, carbon dioxide, nitrogen, helium, or xenon.

10. The propulsion system (150) of any preceding claim, wherein the fluid comprises oil, and wherein the first heat exchanger (410) comprises an air-cooled oil cooler, and wherein the second heat exchanger (412) comprises a fuel-cooled oil cooler.

11. A method for thermal management for an aircraft, the method comprising:
flowing a flow of a fluid through a thermal management system flowpath (401, 501, 701, 801) to a first heat exchanger (410) thermally connected to the thermal management system flowpath (401, 501, 701, 801);
passing the flow of the fluid through the first heat exchanger (410);
splitting the flow of the fluid from the first heat exchanger (410) into a first portion (425, 525, 725, 825) of the flow of the fluid and a second portion (427, 527, 727, 827) of the flow of the fluid;
flowing at least the second portion (427, 527, 727, 827) of the flow of the fluid through the thermal management system flowpath (401, 501, 701, 801) to an electric machine (300A, 300B, 302A, 402, 504, 802, 804) of a gas turbine engine (210A, 210B), the electric machine (300A, 300B, 302A, 402, 504, 802, 804) thermally connected to the thermal management system flowpath (401, 501, 701, 801);
flowing the first portion (425, 525, 725, 825) of the flow of the fluid through the thermal management system flowpath (401, 501, 701, 801) to a second heat exchanger (412) thermally connected to the thermal management system flowpath (401, 501, 701, 801); and
flowing the first portion (425, 525, 725, 825) of the flow of the fluid from the second heat exchanger (412) through the thermal management system flowpath (401, 501, 701, 801) to a power electronics assembly (404, 818) electrically connected to the electric machine (300A, 300B, 302A, 402, 504, 802, 804), the power electronics assembly (404, 818) thermally connected to the thermal management system flowpath (401, 501, 701, 801).

12. The method of claim 11, further comprising splitting the flow of the fluid from the first heat exchanger (410) so that the first portion (425, 525, 725, 825) is equal to or less than the second portion (427, 527, 727, 827).

13. The method of claim 11 or 12, wherein the fluid comprises oil, and wherein flowing the flow of the fluid through the thermal management system flowpath (401, 501, 701, 801) to the first heat exchanger (410) comprises flowing the flow of the oil through the thermal management system flowpath (401, 501, 701, 801) to an air-cooled oil cooler.

14. The method of any of claims 11 to 13, wherein the fluid comprises oil, and wherein flowing the second portion (427, 527, 727, 827) of the flow of the fluid output from the first heat exchanger (410) through the thermal management system flowpath (401, 501, 701, 801) to the second heat exchanger (412) comprises flowing the second portion (427, 527, 727, 827) of the flow of the oil output from the first heat exchanger (410) through the thermal management system flowpath (401, 501, 701, 801) to a fuel-cooled oil cooler.

15. The method of any of claims 11 to 14, further comprising:
combining the first portion (425, 525, 725, 825) of the flow of the fluid with the second portion (427, 527, 727, 827) of the flow of the fluid downstream from the power electronics assembly (404, 818) to form a combined flow of the fluid; and
flowing the combined flow of the fluid through the thermal management system flowpath (401, 501, 701, 801) to the electric machine (300A, 300B, 302A, 402, 504, 802, 804).
